# EUROPEAN PATENT APPLICATION

(11) **EP 1 833 082 A1**
(43) Date of publication of application: **12.09.2007**
(21) Application number: 05814663.0
(22) Date of filing: 06.12.2005
(51) Int. Cl.: H01L 21/027, G03F 7/20

(54) **SUBSTRATE PROCESSING METHOD, EXPOSURE METHOD, EXPOSURE APPARATUS, AND METHOD FOR MANUFACTURING DEVICE**

(30) Priority: 06.12.2004 JP 2004352958
(71) Applicant: NIKON CORPORATION, Tokyo 100-8831 (JP)
(72) Inventor: Fujiwara, Tomoharu, c/o Nikon Corp. IPD, Chiyoda-ku, Tokyo 1008331 (JP); Horiuchi, Takashi, c/o Nikon Corp. IPD, Chiyoda-ku, Tokyo 1008331 (JP)
(74) Representative: Wiebusch, Manfred
(86) International application number: PCT/JP2005/022329
(87) International publication number: WO 2006/062074

(57) **Abstract**

In a substrate-processing method including a step of forming a liquid immersion area AR2 of a liquid LQ on a substrate P and performing exposure for the substrate P by irradiating an exposure light beam EL onto the substrate P through the liquid LQ in the liquid immersion area AR2, a liquid contact time, during which the substrate P is in contact with the liquid LQ in the liquid immersion area AR2, is managed. Accordingly, in a device producing process, it is possible to suppress the occurrence of device defect.

## Description

### TECHNICAL FIELD

The present invention relates to a method for processing a substrate including a step of performing exposure through a liquid, an exposure method, an exposure apparatus, and a method for producing a device.

### BACKGROUND ART

The photolithography process, as one of the producing processes for a microdevice such as a semiconductor device or a liquid crystal display device, uses an exposure apparatus which projects a pattern formed on a mask onto a photosensitive substrate and exposes the substrate with the pattern. This exposure apparatus includes a mask stage which supports a mask and a substrate stage which supports a substrate, and projects an image of the pattern of the mask onto a substrate via a projection optical system while successively moving the mask stage and the substrate stage. In the microdevice production, for higher integration of the device, there is a demand to miniaturize the pattern to be formed on the substrate. To meet this demand, higher resolution of the exposure apparatus is desired. As one of the means for realizing this higher resolution, there is proposed a liquid immersion exposure method in which a liquid immersion area is formed by filling a liquid between a projection optical system and a substrate and to perform exposure process through the liquid in the liquid immersion area, as disclosed in International Publication No. 99/49504.

### DISCLOSURE OF THE INVENTION

### Task to be Solved by the Invention:

When the liquid remains on the substrate and the remaining liquid vaporizes, there is a possibility that an adhesion mark of the liquid is formed on the substrate. In the following, the adhesion mark of the liquid is referred to as a water mark, even when the liquid is not water.
When the water mark is formed, there is a fear that the device manufactured becomes defective. For example, in a case that a substrate is subjected to liquid immersion exposure, and then is subjected to the developing process in a state that a water mark is formed on the substrate, there is a fear that any developing failure occurs, which in turn makes impossible to manufacture a device with a desired performance. To manufacture a device with the desired performance, it is important to suppress the occurrence of the water mark.

The present invention was made in view of the above-described circumstances, and an object of the present invention is to provide a method for processing a substrate, an exposure method, an exposure apparatus, and a method for producing a device which can suppress the occurrence of defect in the device producing process including the liquid immersion exposure step.

### Solution to the Task:

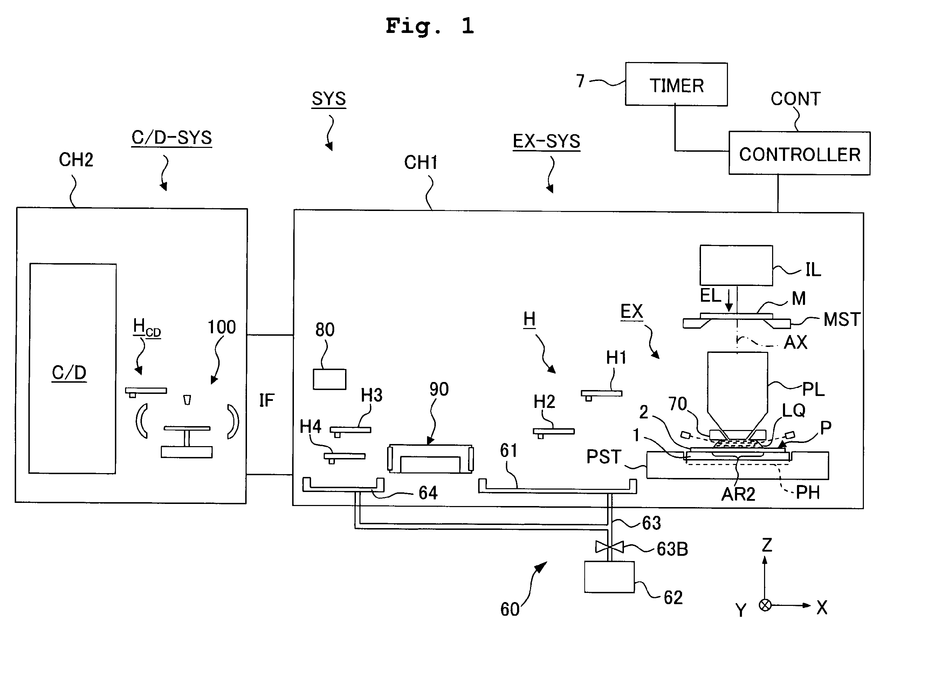

In order to solve the task, the invention adopts the following constructions corresponding to Figs. 1 to 12 as illustrated in the embodiments. However, parenthesized reference numerals affixed to respective elements merely exemplify the elements by way of example, with which it is not intended to limit the respective elements.

According to a first aspect of the present invention, there is provided a method for processing a substrate, comprising: forming a liquid immersion area (AR2) of a liquid (LQ) on a substrate (P) and performing exposure for the substrate (P) by irradiating an exposure light (EL) onto the substrate (P) through the liquid (LQ) in the liquid immersion area (AR2); and managing a liquid contact time during which the substrate (P) is in contact with the liquid (LQ) in the liquid immersion area (AR2).

According to the first aspect of the invention, by managing the liquid contact time during which the substrate is in contact with the liquid (time elapsed after the substrate comes into contact with the liquid), it is possible to prevent any inconvenience or problem that a liquid adhesion mark (water mark) is formed on the substrate.

According to a second aspect of the present invention, there is provided a method for processing a substrate, comprising: forming a liquid immersion area (AR2) of a liquid (LQ) on a substrate (P) and performing exposure for the substrate (P) by irradiating an exposure light (EL) onto the substrate (P) through the liquid (LQ) in the liquid immersion area (AR2); removing the liquid immersion area on the substrate; and managing a time after the liquid immersion area (AR2) has been removed on the substrate (P).

According to the second aspect of the invention, by managing a time after the liquid immersion area has been removed on the substrate, it is possible to prevent any inconvenience such that a liquid adhesion mark (water mark) is formed on the substrate.

Here, the phrase "removing the liquid immersion area on the substrate" includes not only recovering the liquid on the substrate (from a surface of the substrate) by using a liquid recovery mechanism but also moving the liquid from the surface of the substrate onto another member, and the method for removing the liquid immersion area on the substrate or a mechanism to be used for this operation is arbitrary. In some cases, even when the process for removing the liquid immersion area on the substrate is performed, drops or droplets of the liquid remains on the surface of the substrate depending on the affinity for the liquid on the surface of the substrate. The present invention can cope also with such a situation. Therefore, in the present application, the phrase "a state after the liquid immersion area has been removed on the substrate" means not only a state that the liquid has been completely removed from the surface of the substrate but also a state that droplets or the like of the liquid remain on the substrate even after the liquid immersion area has been removed on the substrate.

According to a third aspect of the present invention, there is provided a method for processing a substrate, comprising: forming a liquid immersion area (AR2) of a liquid (LQ) on a substrate (P) and performing exposure for the substrate (P) by irradiating an exposure light (EL) onto the substrate (P) through the liquid (LQ) in the liquid immersion area (AR2); removing the liquid immersion area (AR2) on the substrate (P); and setting a contact angle of the substrate (P) with respect to the liquid (LQ) so that the liquid (LQ) remains on the substrate (P) after the liquid immersion area (AR2) has been removed on the substrate (P).

According to the third embodiment of the invention, the contact angle of the substrate with respect to the liquid is set so that the liquid remains on the substrate after the liquid immersion area has been removed on the substrate, thereby making it possible to prevent any inconvenience such that an adhesion mark (water mark) of the liquid is formed on the surface of the substrate.

Here, the phrase "remove the liquid immersion area on the substrate" includes not only recovering the liquid from a surface of the substrate by using a liquid recovery mechanism but also moving the liquid from the surface of the substrate onto another member, and the method for removing the liquid immersion area on the substrate or a mechanism to be used for this operation is arbitrary.

According to a fourth aspect of the present invention, there is provided an exposure apparatus (EX) which forms a liquid immersion area (AR2) of a liquid (LQ) on a substrate (P) and exposes the substrate (P) by irradiating an exposure light (EL) onto the substrate (P) through the liquid (LQ) in the liquid immersion area (AR2), the apparatus comprising: a substrate holder (PH) which holds the substrate (P); a liquid removing mechanism (20, 90) which removes the liquid (LQ) on the substrate (P); and a controller (CONT) which manages a liquid contact time during which the substrate (P) is in contact with the liquid (LQ) in the liquid immersion area (AR2).

According to the fourth aspect of the invention, the controller manages the liquid contact time, during which the substrate is in contact with the liquid (time elapsed after the substrate begins to come into contact with the liquid), thereby making it possible to prevent any inconvenience such that an adhesion mark (water mark) of the liquid is formed on the substrate.

According to a fifth aspect of the present invention, there is provided an exposure apparatus (EX) which forms a liquid immersion area (AR2) of a liquid (LQ) on a substrate (P) and exposes the substrate (P) by irradiating an exposure light (EL) onto the substrate (P) through the liquid (LQ) in the liquid immersion area (AR2), the apparatus comprising: a substrate holder (PH) which holds the substrate (P); and a transport system (H) which transports from the substrate holder (PH) a substrate (P), which has come into contact with the liquid (LQ) forming the liquid immersion area (AR2), in a wet state.

According to the fifth aspect of the invention, by transporting the substrate, which has come into contact with the liquid in the liquid immersion area, from the substrate holder with the transport system while the substrate is in a wet state, it is possible to prevent any inconvenience such that any adhesion mark (water mark) of the liquid is formed on the substrate.

According to a sixth aspect of the present invention, there is provided an exposure apparatus (EX) which forms a liquid immersion area (AR2) of a liquid (LQ) on a substrate (P) and exposes the substrate (P) by irradiating an exposure light (EL) onto the substrate (P) through the liquid (LQ) in the liquid immersion area (AR2), the apparatus comprising: a substrate holder (PH) which holds the substrate (P); and a controller (CONT) which manages a liquid contact time during which the substrate (P) is in contact with the liquid (LQ) in the liquid immersion area (AR2). According to the sixth aspect of the invention, the controller manages the liquid contact time during which the substrate is in contact with the liquid (time elapsed after the substrate begins to coming into contact with the liquid), to thereby make it possible to form a desired pattern on the substrate.

According to a seventh aspect of the present invention, there is provided an exposure method, comprising using the method for processing the substrate according to the above-described aspects. According to the seventh aspect of the invention, it is possible to prevent the occurrence (formation) of adhesion mark (water mark), thereby making it possible to form a desired exposure pattern.

According to an eighth aspect of the present invention, there is provided a method for producing a device, comprising using the exposure apparatus (EX) according to the above-described aspects. According to the eighth aspect of the invention, it is possible to suppress the occurrence of adhesion mark (water mark), thereby making it possible to produce a device with desired performance.

### Effect of the Invention:

According to the present invention, it is possible to suppress the occurrence of device defect, thereby making it possible to produce a device with desired performance.

### BRIEF DESCRIPTION OF THE DRAWINGS

Fig. 1 is a schematic construction view showing an embodiment of a device producing system including an exposure apparatus;
Fig. 2 is a sectional view showing an example of a substrate;
Fig. 3 is a schematic construction view showing an example of a body of the exposure apparatus;
Fig. 4 is a diagram showing a state that a substrate is exposed through a liquid in a liquid immersion area;
Fig. 5 is a sectional view showing another example of the substrate;
Figs. 6(A) and 6(B) show a flowchart of exemplary operations of the device producing system;
Fig. 7 is a diagram showing a state that a transport system is transporting a substrate which is in a wet state;
Fig. 8 is a diagram showing an example of a cleaning device;
Fig. 9 is a diagram showing an example of a liquid removing system;
Fig. 10 is a diagram showing a state that a liquid immersion area is moving between a substrate stage and a measuring stage;
Fig. 11 is a flowchart showing another example of operations of the device producing system; and
Fig. 12 is a flowchart showing an exemplary process for producing a microdevice.

### Legends of Reference Numerals

1: base material, 2: photosensitive material (film), 3: protective film (film), 10: liquid supply mechanism, 20: liquid recovery mechanism, 90: liquid removing system, 100: cleaning device, 300: liquid immersion mechanism, AR2: liquid immersion area, C/D-SYS: coater/developer, CONT: controller, EL: exposure light (exposure light beam), EX: exposure apparatus-body, EX-SYS: exposure apparatus, H: transport system, LQ: liquid, P: substrate, PH: substrate holder, SYS: device producing system

### BEST MODE FOR CARRYING OUT THE INVENTION

In the following, an embodiment of the invention will be described with reference to the drawings. However, the present invention is not limited to the embodiment.

Fig. 1 shows an embodiment of a device producing system including an exposure apparatus of the invention. In Fig. 1, the device producing system SYS includes an exposure apparatus EX-SYS and a coater/developer C/D-SYS.

The exposure apparatus EX-SYS includes an interface IF which forms a connecting portion at which the exposure apparatus EX-SYS is connected to the coater/developer C/D-SYS; an exposure apparatus-body EX which performs exposure of a substrate P; a transport system H which transports the substrate P; and a controller CONT which controls overall operations of the exposure apparatus EX-SYS. The controller CONT includes a timer 7 for managing a time relating to the exposure.

The exposure apparatus-body EX includes a mask stage MST which is movable while holding a mask M thereto; a substrate stage PST having a substrate holder PH which holds a substrate P thereto and capable of moving the substrate holder PH with the substrate P held to the substrate holder PH; an illumination optical system IL which illuminates the mask M held to the mask stage MST with an exposure light (exposure light beam) EL; and a projection optical system PL which projects an image of a pattern of the mask M illuminated by the exposure light bema EL onto the substrate P. The term "substrate" referred herein includes a substrate having a photosensitive material (resist) coated on a base material such as a semiconductor wafer or the like, and the term "mask" includes a reticle having a device pattern which is to be subjected to the reduction projection onto the substrate.

The exposure apparatus-body EX is a liquid immersion exposure apparatus to which the liquid immersion method is applied to improve the resolution by substantially shortening the exposure wavelength and to substantially widen the depth of focus, which forms a liquid immersion area AR2 of the liquid LQ on the substrate P held on the substrate stage PST, and which exposes the substrate P by irradiating the exposure light beam EL onto the substrate P through the liquid LQ in the liquid immersion area AR2.

This embodiment will now be explained as exemplified by a case using a scanning type exposure apparatus (so-called scanning stepper) as the exposure apparatus-body EX which exposes the substrate P with the pattern formed on the mask M while synchronously moving the mask M and the substrate P in mutually different directions (opposite directions) in the scanning direction. In the following explanation, an X-axis direction is a synchronous movement direction (scanning direction) of the mask M and the substrate P in a horizontal plane, the Y-axis direction (non-scanning direction) is a direction orthogonal to the X-axis direction in the horizontal plane, and a Z-axis direction is a direction which is perpendicular to the X-axis direction and the Y-axis direction and is coincident with an optical axis AX of the projection optical system PL. The directions of rotation (inclination) about the X-axis, the Y-axis, and the Z-axis are defined as θX, θY, and θZ directions, respectively.

The exposure apparatus EX-SYS includes a liquid removing system 90 which is provided at an intermediate position in a transport path of a transport system H and which removes the liquid LQ on the substrate P after the substrate P has been subjected to liquid immersion exposure; and an imaging device 80 for imaging the surface of the substrate P. The imaging result of the imaging device 80 is outputted to the controller CONT, and the controller CONT can obtain surface information of the substrate P based on the imaging result of the imaging device 80. The imaging device 80 is supported by a drive mechanism (not shown in the drawing), and is provided movably along the transport path of the transport system H.

The coater/developer C/D-SYS is provided with a coater/developer-body C/D including: a coater (not shown) which coats a photosensitive material (resist) on a base material (semiconductor wafer) of the substrate P before the substrate P is exposed and a developer (not shown) which develops the substrate P after the substrate P has been exposed in the exposure apparatus-body EX; a transport system H_{CD} which transports the substrate P; and a cleaning device 100 which cleans or washes the substrate P. The exposure apparatus EX-SYS may be provided with the cleaning device 100.

The exposure apparatus-body EX and the transport system H, etc., are arranged inside a first chamber CH1 in which cleanness etc. is managed. On the other hand, the coater/developer-body C/D and the transport system H_{CD}, etc., are arranged inside a second chamber CH2 different from the first chamber CH1. The first chamber CH1 and the second chamber CH2 are connected via the interface IF.

The transport system H includes a plurality of transport arms H1 to H4 which transport the substrate P between the interface IF and the exposure apparatus-body EX. The transport system H includes a first transport arm H1 which loads a substrate P before being exposed to the substrate stage PST (substrate holder PH) and a second transport am H2 which unloads the exposed substrate P from the substrate stage PST (substrate holder PH). Further, the transport system H includes third and fourth transport arms H3 and H4 which transport the exposed substrate P to the interface IF.

Here, the transport procedures of the substrate P will be briefly described. The substrate P onto which a photosensitive material is coated by the coater of the coater/developer-body C/D is transported to the interface IF by the transport system H_{CD}. The substrate P transported to the interface IF is delivered to a pre-alignment unit (not shown) provided in the exposure apparatus EX-SYS. Here, an opening and a shutter for opening and closing the opening is provided on a portion, of each of the first and second chambers CH1 and CH2, which is opposite to or which faces the interface IF, and during an operation for transporting the substrate P to the interface IF, the shutter is open. The substrate P delivered to the pre-alignment unit is roughly aligned to be roughly positioned with respect to the substrate stage PST, in the pre-alignment unit. At this time, the imaging device 80 images the surface of the substrate P held at the pre-alignment unit and outputs the imaging result to the controller CONT. The controller CONT obtains surface information of the substrate P before the substrate is exposed, based on the imaging result of the imaging device 80. When the surface of the substrate P before being exposed is imaged by the imaging device 80, the imaging device 80 is arranged at a position above or over the substrate P, held at the pre-alignment unit, by an unillustrated driving mechanism.

The controller CONT loads the substrate P, subjected to the position alignment by the pre-alignment unit, onto the substrate stage PST (substrate holder PH) by the first transport arm H1. The controller CONT performs liquid immersion exposure for the substrate P loaded onto the substrate stage PST, and then unloads the exposed substrate P from the substrate stage PST (substrate holder PH) by the second transport arm H2. At this time, the imaging device 80 images the surface of the substrate P held to the second transport arm H2, and outputs the imaging result to the controller CONT. The controller CONT obtains surface information of the exposed substrate P based on the imaging result of the imaging device 80. When the surface of the exposed substrate P is imaged by the imaging device 80, the imaging device 80 is arranged at a position over or above the substrate P, held to the second transport arm H2, by an unillustrated driving mechanism.

The controller CONT transports the exposed substrate P, unloaded from the substrate stage PST, by the second transport arm H2 to the interface IF.
Alternatively, the controller CONT can deliver the exposed substrate P unloaded from the substrate stage PST by the second transport arm H2 to the fourth transport arm H4 and transports the substrate to the interface IF by the fourth transport arm H4.

In the transport path of the transport system H, the liquid removing system 90 is provided, and the controller CONT can deliver the exposed substrate P unloaded from the substrate PST by the second transport arm H2 to the liquid removing system 90. In this case, the controller CONT delivers, via the liquid removing system 90, the exposed substrate P which is unloaded from the substrate stage PST by the second transport arm H2 to one of the third transport arm H3 and the fourth transport arm H4. The controller CONT selects one of the third transport arm H3 and the fourth transport arm H4 depending on the details of processing by the liquid removing system 90, and the controller CONT delivers the substrate P to the interface IF by using the selected transport arm (H3 or H4).

The exposed substrate P transported to the interface IF is delivered to the transport system H_{CD} of the coater/developer C/D-SYS. The transport system H_{CD} transports the exposed substrate P to the cleaning device 100. The cleaning device 100 cleans the exposed substrate P. The transport system H_{CD} transports the substrate P after being cleaned by the cleaning device 100 to the developer of the coater/developer-body C/D. The developer of the coater/developer-body C/D performs developing process for the transported substrate P.

As described above, the first transport arm H1 holds the substrate P to which the liquid LQ is not adhered before the exposure, and loads the substrate P onto the substrate stage PST. On the other hand, the second transport arm H2 holds the substrate P after subjected to the liquid immersion exposure to which the liquid LQ may be adhered, and unloads the substrate P from the substrate stage PST. Thus, since the first transport arm H1 which transports the substrate P to which the liquid LQ is not adhered and the second transport arm H2 which transports the substrate P to which the liquid LQ may be adhered are used independently, the liquid LQ does not adhere to the first transport arm H1, and it is possible to prevent the liquid LQ from adhering to the back surface of the substrate P to be loaded onto the substrate stage PST. Therefore, even when the substrate holder PH of the substrate stage PST holds the substrate P by vacuum-attraction, it is possible to prevent a problem such that the liquid LQ inflows into the vacuum system such as a vacuum pump through an attraction hole of the substrate holder PH.

The liquid removing system 90 removes the liquid LQ on the substrate P after the liquid immersion exposure has been performed for the substrate P. However, as will be described later, in some cases the controller CONT does not perform the operation by the liquid removing system 90 for removing the liquid LQ on the substrate P after the substrate has been subjected to the liquid immersion exposure. In a case that the controller CONT performs the operation by the liquid removing system 90 for removing the liquid LQ on the substrate P after the liquid immersion exposure, the controller takes out the substrate P from the liquid removing system 90 and transports the substrate P by the third transport arm H3. On the other hand, in a case that the controller does not perform the operation for removing the liquid LQ on the substrate P, the controller transports the substrate P by the fourth transport arm H4. Thus, the third transport arm H3 which transports the substrate P subjected to the liquid removal process by the liquid removing system 90 and the fourth transport arm H4 which transports the substrate P which has not been subjected to the liquid removal process and to which the liquid LQ may be adhered are used independently. Accordingly, the adhesion of the liquid LQ to the third transport arm H3 is prevented.

In the transport path of the substrate P, a recovery mechanism 60 which recovers the liquid LQ scattered (fell) from the exposed substrate P is provided. The recovery mechanism 60 includes a gutter member 61 disposed at a position below or under the transport path of the transport system H (second transport arm H2) between the substrate stage PST and the liquid removing system 90, and a liquid-sucking device 62 which discharges the liquid LQ recovered by the gutter member 61 from the gutter member 61. The gutter member 61 is provided inside the first chamber CH1, and the liquid-sucking device 62 is provided outside the first chamber CH1. The gutter member 61 and the liquid-sucking device 62 are connected via a duct 63, and a valve 63B which opens/closes the flow channel of this duct 63 is provided in the duct 63. The recovery mechanism 60 also includes a gutter member 64 disposed at a position below or under the transport path of the transport system H (fourth transport arm H4) between the liquid removing system 90 and the interface IF, and the liquid LQ recovered by the gutter member 64 is also discharged from the gutter member 64 by the liquid-sucking device 62. When the transport system H transports a substrate P to which the liquid LQ is adhered, there is a possibility that the liquid LQ falls from the substrate P. However, such fallen or dropped liquid LQ can be recovered by the gutter members 61 and 64. By recovering the fallen liquid LQ by the gutter members 61 and 64, it is possible to prevent a problem such that the liquid LQ from the substrate P adheres to a peripheral device, a member on the transport path, and/or the like. The liquid-sucking device 62 sucks the liquid LQ on the gutter members 61 and 64 provided inside the chamber CH1, to thereby discharge the liquid to the outside of the chamber CH1 so as to prevent the liquid LQ from stagnating or remaining in the gutter members 61 and 64 inside the chamber CH1. Therefore, a problem such as humidity fluctuation (environment fluctuation) inside the chamber CH1 can be prevented. Here, the liquid-sucking device 62 is capable of both continuously sucking the liquid LQ recovered by the gutter members 61 and 64 and intermittently sucking the liquid LQ only for predetermined periods of time. By continuously performing the sucking operation, the liquid LQ does not remain in the gutter members 61 and 64, which in turn further prevents the humidity fluctuation from occurring inside the chamber CH1. On the other hand, for example, during the exposure of the substrate P by the exposure apparatus-body EX, the sucking operation (discharge operation) by the liquid-sucking device 62 is not performed. Rather, the sucking operation is performed only in a period of time other than the exposure time, thereby preventing a problem such that vibration caused by the sucking operation affects the exposure accuracy.

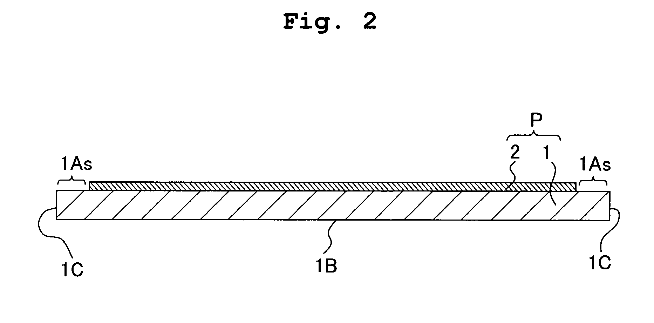

Fig. 2 shows an example of the substrate P after being subjected to the coating by the coater/developer-body C/D. In Fig. 2, the substrate P has a base material 1, and a film 2 formed on an upper surface 1A of the base material 1. The base material 1 includes a silicon wafer. The film 2 is made of a photosensitive material (resist), and is coated on the upper surface 1A of the base material 1 at an area occupying most of the central portion of the upper surface 1A, to a predetermined thickness (for example, about 200 µm). In this embodiment, as the photosensitive material, a chemically-amplified resist is used. On the other hand, the photosensitive material (film) 2 is not coated on a peripheral edge portion 1As of the upper surface 1A of the base material 1, and the base material 1 is exposed in the peripheral edge portion 1As of the upper surface 1A. Further, the photosensitive material 2 is not coated also on a side surface 1C and a lower surface 1B of the base material 1. When the photosensitive material 2 is coated on the base material 1 by a predetermined coating method such as spin coating, in some cases, a phenomenon occurs that the photosensitive material 2 is coated in a large amount on the peripheral edge portion of the base material 1 so as to pile up higher than the central portion. Such photosensitive material 2 on the peripheral edge portion of the base material 1 is easily peeled off or exfoliated, and the exfoliated photosensitive material 2 becomes a foreign matter, and if the foreign matter adheres to the surface of the substrate P, the foreign matter affects the pattern transfer accuracy. Therefore, after the photosensitive material 2 is provided on the base material 1 by the predetermined coating method, a process (so-called edge rinsing) for removing the photosensitive material 2 on the peripheral edge portion 1As by using, for example, a solvent, is performed before performing the exposure. With this, the photosensitive material 2 is removed at the peripheral edge portion of the base material 1 (substrate P), and the base material 1 is exposed in the peripheral edge portion 1As.

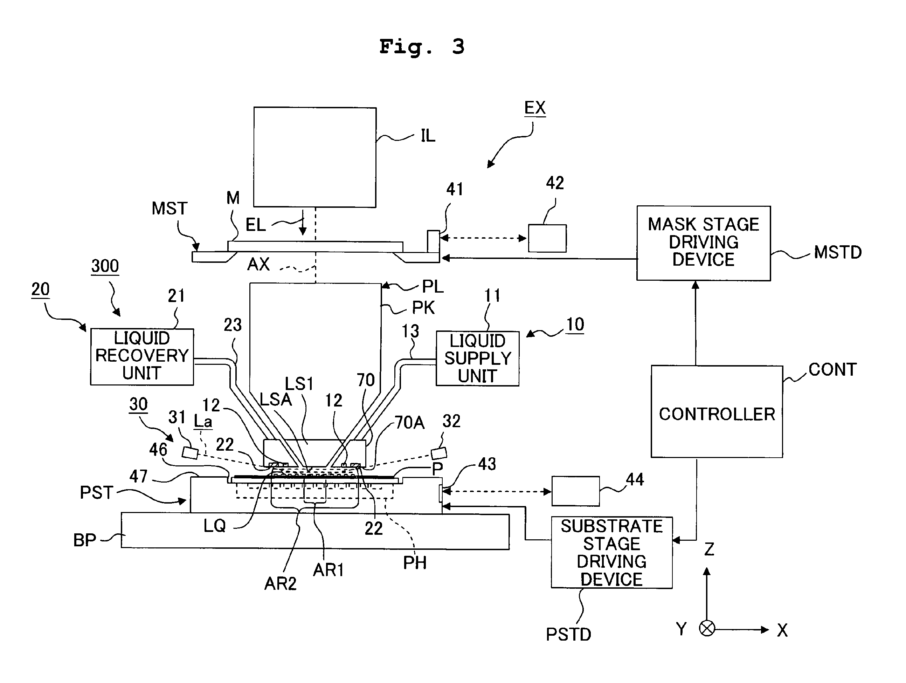

Next, the exposure apparatus-body EX will be described with reference to Fig. 3. Fig. 3 is a schematic construction view showing the exposure apparatus-body EX. The exposure apparatus-body EX exposes a substrate P based on the liquid immersion method, and has a liquid immersion mechanism 300 for filling, with the liquid LQ, the optical path space for the exposure light beam EL on the side of the image plane of the projection optical system PL. The liquid immersion mechanism 300 includes a nozzle member 70 which is provided in the vicinity of the image plane of the projection optical system PL and which has a supply port 12 for supplying the liquid LQ and a recovery port 22 for recovering the liquid LQ; a liquid supply mechanism 10 which supplies the liquid LQ to the side of the image plane of the projection optical system PL through the supply port 12 provided in the nozzle member 70; and a liquid recovery mechanism 20 which recovers the liquid LQ on the side of the image plane of the projection optical system PL through the recovery port 22 provided in the nozzle member 70. The nozzle member 70 is formed in an annular shape so as to surround, at a position above or over the substrate P (substrate stage PST), a first optical element LS1 closest to the image plane of the projection optical system PL among a plurality of optical elements constructing the projection optical system PL.

The exposure apparatus EX adopts the local liquid immersion method in which, at least during a time (period of time) in which an image of the pattern of the mask M is being projected onto the substrate P, a liquid immersion area AR2 of the liquid LQ which is larger than the projection area AR1 and smaller than the substrate P is locally formed, with the liquid LQ supplied from the liquid supply mechanism 10, on the substrate P at a part (portion) thereof, the portion including the projection area AR of the projection optical system PL. Specifically, the exposure apparatus EX fills, with the liquid LQ, the optical path space for the exposure light beam EL between a lower surface LSA of the first optical element LS1 which is closest to the image plane of the projection optical system PL and an upper surface of the substrate P arranged on the side of the image plane of the projection optical system PL, and the exposure apparatus EX irradiates the exposure light beam EL passing through the mask M, via the projection optical system PL and the liquid LQ filled in the optical path space, onto the substrate P to thereby expose the image of the pattern of the mask M on the substrate P. The controller CONT forms the liquid immersion area AR2 of the liquid LQ on the substrate P by supplying a predetermined amount of the liquid LQ onto the substrate P by using the liquid supply mechanism 10 and by recovering a predetermined amount of the liquid LQ on the substrate P by using the liquid recovery mechanism 20.

The illumination optical system IL includes an exposure light source; an optical integrator which uniformizes the illuminance of a light flux radiated from the exposure light source; a condenser lens which collects the exposure light beam EL from the optical integrator; a relay lens system; and a field diaphragm which defines an illumination area on the mask M to be illuminated with the exposure light beam EL. The predetermined illumination area on the mask M is illuminated by the exposure light beam EL having a uniform illuminance distribution by the illumination optical system IL. Those usable as the exposure light beam EL emitted from the illumination optical system IL include, for example, emission lines (g-ray, h-ray, i-ray) radiated, for example, from a mercury lamp, far ultraviolet light beams (DUV light beams) such as a KrF excimer laser beam (wavelength: 248 nm), and vacuum ultraviolet light beams (VUV light beams) such as an ArF excimer laser beam (wavelength: 193 nm), a F₂ laser beam (wavelength: 157 nm), and the like. In this embodiment, the ArF excimer laser beam is used.

In this embodiment, pure or purified water is used as the liquid LQ forming the liquid immersion area AR2. Those transmissive through pure or purified water include the ArF excimer laser beam as well as the emission lines (g-ray, h-ray, i-ray) emitted, for example, from a mercury lamp and the far ultraviolet light beams (DUV light beams) such as the KrF excimer laser beam (wavelength: 248 nm).

The mask stage MST is movable while holding the mask M. The mask stage MST holds the mask M by vacuum attraction (or electrostatic attraction). The mask stage MST is two-dimensionally movable in a plane perpendicular to the optical axis AX of the projection optical system PL, namely the XY plane and is finely rotatable in the θZ direction while holding the mask M by the driving of the mask stage driving device MSTD which includes a linear motor or the like and which is controlled by the controller CONT. On the mask stage MST, a movement mirror 41 which moves together with the mask stage MST is fixedly provided. Further, a laser interferometer 42 is provided at a position at which the laser interferometer 42 is opposite to or facing the movement mirror 41. The position in the two-dimensional direction (XY directions) and an angle of rotation in the θZ direction (including angle of rotation in the θX, θY directions in some cases) of the mask M on the mask stage MST are measured by the laser interferometer 42 in real-time. The result of measurement by the laser interferometer 42 is outputted to the controller CONT. The controller CONT controls the mask stage driving device MSTD based on the measurement result of the laser interferometer 42 to drive the mask stage MST, thereby controlling the position of the mask M held on the mask stage MST.

The projection optical system PL projects the image of the pattern of the mask M onto the substrate P at a predetermined projection magnification β. The projection optical system PL includes a plurality of optical elements, and these optical elements are held by a barrel PK. In this embodiment, the projection optical system PL is a reduction system with a projection magnification β of, for example, 1/4, 1/5, or 1/8. The projection optical system PL may be an x1 magnification system or a magnifying system. In this embodiment, the first optical element LS1 closest to the image plane of the projection optical system PL among the plurality of optical elements constructing the projection optical system PL is exposed from the barrel PK. Although the projection optical system PL of the embodiment is the dioptric system including no catoptric element, the projection optical system PL may be the catoptric system including no dioptric element, or the catadioptric system including dioptric and catoptric elements.

The substrate stage PST has a substrate holder PH which holds the substrate P, and is movable on the base member BP on the side of the image plane of the projection optical system PL. The substrate holder PH holds the substrate P by, for example, vacuum attraction. On the substrate stage PST, a recess 46 is provided (formed), and the substrate holder PH for holding the substrate P is disposed in the recess 46. Further, an upper surface 47, except for the recess 46, of the substrate stage PST, is formed to be a flat surface (flat portion) having a height approximately same as the height of (flush with) the surface of the substrate P held on the substrate holder PH.

The substrate stage PST is movable in the two-dimensional direction (XY direction) and finely rotatable in the θZ direction on the base member BP within the XY plane in a state that the substrate stage PST holds the substrate P via the substrate holder PH by being driven by the substrate stage-driving device PSTD which includes a linear motor or the like and which is controlled by the controller CONT. Further, the substrate stage PST is movable also in the Z-axis, in the θX direction, and in the θY direction. Therefore, the upper surface of the substrate P supported by the substrate stage PST is movable in the six degree of freedom in the X-axis, Y-axis, Z-axis, θX, θY, and θZ directions. A movement mirror 43 which moves together with the substrate stage PST is fixedly provided on a side surface of the substrate stage PST. Further, at a position facing the movement mirror 43, a laser interferometer 44 is provided. The position in the two-dimensional direction and the angle of rotation of the substrate P on the substrate stage PST are measured in real-time by the laser interferometer 44. The exposure apparatus EX includes a focus/leveling-detecting system 30 of an oblique incidence type which detects position information of the surface of the substrate P supported by the substrate stage PST. The focus/leveling-detecting system 30 includes a light-projector 31 which projects a detection light beam La onto the upper surface of the substrate P and a light receiver 32 which receives a reflected light of the detection light beam La reflected by the upper surface of the substrate P, and detects surface position information of the upper surface of the substrate P (position information in the Z-axis direction and inclination information in the θX and θY directions of the substrate P). The measurement result of the laser interferometer 44 is outputted to the controller CONT. The detection result of the focus/leveling-detecting system 30 (light receiver 32) is also outputted to the controller CONT. The controller CONT drives the substrate stage driving device PSTD based on the detection result of the focus/leveling-detecting system 30 to match the upper surface of the substrate P with the image plane of the projection optical system PL by controlling the focus position (Z position) and the inclination angles (θX, θY) of the substrate P, and performs position control in the X-axis direction, Y-axis direction, and θZ direction of the substrate P based on the measurement result of the laser interferometer 44.

Next, the liquid supply mechanism 10 and the liquid recovery mechanism 20 of the liquid immersion mechanism 300 will be described. The liquid supply mechanism 10 supplies the liquid LQ to the side of the image plane of the projection optical system PL. The liquid supply mechanism 10 includes a liquid supply unit 11 capable of feeding out the liquid LQ and a supply tube 13 one end of which is connected to the liquid supply unit 11. The other end of the supply tube 13 is connected to the nozzle member 70. An internal flow channel (supply flow channel) which connects the other end of the supply tube 13 and the supply port 12 is formed in the nozzle member 70. The liquid supply unit 11 includes a tank which accommodates the liquid LQ, a pressurizing pump, a filter unit which removes a foreign matter from the liquid LQ, and the like. It is not necessarily indispensable that the exposure apparatus EX is provided with all of the tank, pressurizing pump, filter unit and the like of the liquid supply mechanism 10, and it is allowable that facilities or equipments of the factory in which the exposure apparatus EX is installed are used instead. The operation of the liquid supply unit 11 is controlled by the controller CONT.

The liquid recovery mechanism 20 recovers the liquid LQ on the side of the image plane of the projection optical system PL. The liquid recovery mechanism 20 includes a liquid recovery unit 21 capable of recovering the liquid LQ and a recovery tube 23 one end of which is connected to the liquid recovery unit 21. The other end of the recovery tube 23 is connected to the nozzle member 70. An internal flow channel (recovery flow channel) which connects the other end of the recovery tube 23 and the recovery port 22 is formed in the nozzle member 70. The liquid recovery unit 21 includes a vacuum system such as a vacuum pump (sucking device), a gas/liquid separator which separates the recovered liquid LQ and a gas, a tank which accommodates the recovered liquid LQ, and the like. It is not necessarily indispensable that the vacuum system, gasliquid separator, tank and the like of the liquid recovery mechanism 20 are all included in the exposure apparatus EX, and it is allowable that facilities or equipments of the factory in which the exposure apparatus EX is installed are used instead. The operation of the liquid recovery unit 21 is controlled by the controller CONT.

The supply port 12 for supplying the liquid LQ and the recovery port 22 for recovering the liquid LQ are formed in the lower surface 70A of the nozzle member 70. The lower surface 70A of the nozzle member 70 is provided at a position opposite to or facing the upper surface of the substrate P and the upper surface 47 of the substrate stage PST. The nozzle member 70 is an annular member provided so as to surround the side surface of the optical element LS1, and the supply port 12 is provided as a plurality of supply ports 12 formed in the lower surface 70A of the nozzle member 70 so as to surround the first optical element LS1 of the projection optical system PL (optical axis AX of the projection optical system PL). The recovery port 22 is formed in the lower surface 70A of the nozzle member 70 so as to be separated further outwardly, than the supply ports 12, with respect to the first optical element LS1 and to surround the first optical element LS1 and the supply ports 12.

The controller CONT supplies a predetermined amount of the liquid LQ onto the substrate P by using the liquid supply mechanism 10 and recovers a predetermined amount of the liquid LQ on the substrate P by using the liquid recovery mechanism 20, thereby locally forming the liquid immersion area AR2 of the liquid LQ on the substrate P. Upon forming the liquid immersion area AR2 of the liquid LQ, the controller CONT drives the liquid supply unit 11 and the liquid recovery unit 21. When the liquid LQ is fed out from the liquid supply unit 11 under the control of the controller CONT, the liquid LQ fed out from the liquid supply unit 11 flows through the supply tube 13, and then the liquid LQ is supplied to the side of the image plane of the projection optical system PL from the supply ports 12 via the supply flow channel of the nozzle member 70. When the liquid recovery unit 21 is driven under the control of the controller CONT, the liquid LQ on the side of the image plane of the projection optical system PL flows into the recovery flow channel of the nozzle member 70 through the recovery port 22, flows through the recovery tube 23, and then the liquid LQ is recovered by the liquid recovery unit 21.

At least a part of the liquid LQ recovered by the liquid recovery mechanism 20 may be returned to the liquid supply mechanism 10. Alternatively, it is also allowable that the liquid LQ recovered by the liquid recovery mechanism 20 is all discarded and new and clean liquid LQ is supplied from the liquid supply mechanism 10. The structure of the liquid immersion mechanism 1 including the nozzle member 70, etc., is not limited to the above-described structure, and it is also possible to use the structure described, for example, in European Patent Publication No. 1420298, International Publication Nos. 2004/055803, 2004/057589, 2004/057590, and 2005/029559.

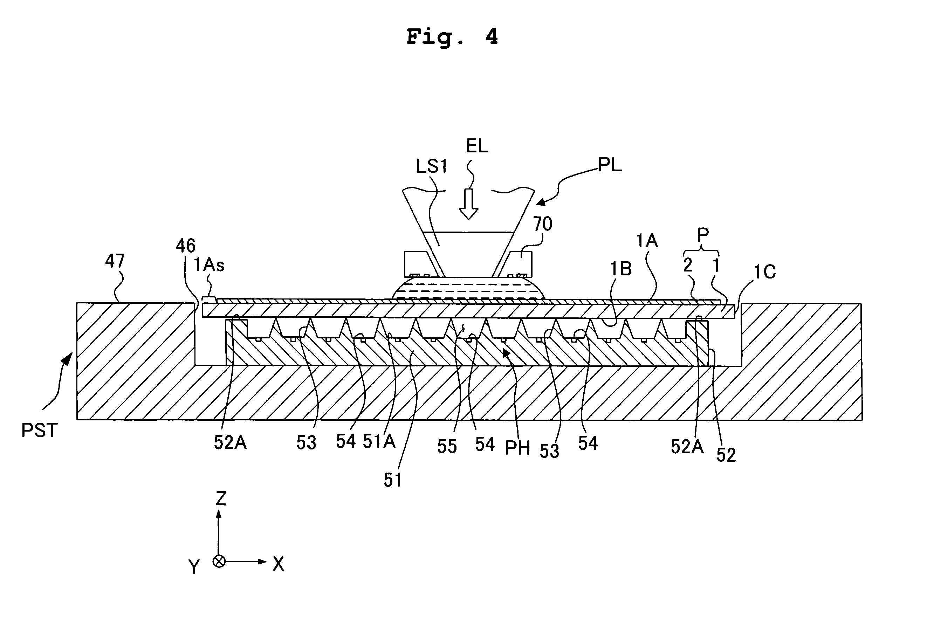

Fig. 4 is a sectional view showing a state that the substrate P held on the substrate holder PH is subjected to the liquid immersion exposure. The substrate holder PH is disposed in the recess 46 of the substrate stage PST, and includes a base member 51 having an upper surface 51A opposite to or facing the lower surface 1B of the substrate P (base material 1); a peripheral wall 52 provided on the upper surface 51A of the base member 51 and having an upper surface 52A which has an approximately annular shape in a plan view and which is opposite to or facing the peripheral edge area of the lower surface 1B of the substrate P; and a plurality of pin-shaped supports 53 provided inside the peripheral wall 52 of the upper surface 51A of the base member 51. A plurality of attraction holes 54 connected to an unillustrated vacuum system are formed on the upper surface 51A of the base member 51 at positions different from the positions at which the supports 53 are provided. Namely, the substrate holder PH forms a part of a so-called pin chuck mechanism, and the controller CONT drives the vacuum system connected to the attraction holes 54 and sucks a gas in a space 55 surrounded by the upper surface 51A of the base member 51, the peripheral wall 52, and the lower surface 1B of the substrate P through the attraction holes 54 to negatively pressurize the space 55, thereby supporting the lower surface 1B of the substrate P with the supports 53.

As shown in Fig. 4, when the liquid immersion area AR2 of the liquid LQ is formed on the substrate P and the liquid LQ and the photosensitive material 2 are brought into contact with each other, there is a possibility that the liquid LQ and the base material 1 come into contact with each other via the photosensitive material 2. For example, when the liquid LQ permeates through the photosensitive material 2 and the permeated liquid LQ and the base material 1 come into contact with each other, or when a part of the photosensitive material 2 has a coating defect, then there is a possibility that the liquid LQ and the base material 1 come into contact with each other via the defective coating portion. Further, in some cases, when the peripheral edge region of the upper surface of the substrate P is subjected to the liquid immersion exposure, the liquid LQ and the peripheral edge 1As of the base material 1 come into contact with each other.

It is generally appreciated that an adhesion mark (water mark) of a liquid is a dry residue formed of the drying of the liquid containing impurity or impurities (contaminated liquid) is dried. A silica compound produced from silicon as a material forming the base material 1 eluted in the liquid LQ in the liquid immersion area AR2 is one of the impurities which causes the water mark. When the base material 1 containing silicon reacts to oxygen, an oxide film (SiO₂) is formed on the surface of the substrate 1. It is considered that the oxide film (SiO₂) is formed due to the reaction of the base material 1 to oxygen in the atmosphere before the base material 1 and the liquid LQ come into contact with each other; and after the base material 1 and the liquid LQ come into contact with each other, the oxide film is formed due to the reaction of the base material 1 to dissolved oxygen in the liquid LQ and/or oxygen dissolved in the liquid LQ from the atmosphere, in addition to the reaction of the base material 1 to oxygen in the atmosphere. In a case that the oxide film is formed on the upper surface 1A of the base material 1, when the oxide film on the upper surface 1A and the liquid LQ come into contact with each other via the photosensitive material 2 (not via the photosensitive material 2 at the peripheral edge 1As), then the oxide film formed on the base material 1 is eluted in the liquid LQ, becomes a silica compound (H₂SiO₃) and diffuses in the liquid LQ.
The silica compound eluted in the liquid LQ becomes the impurity which causes the generation of the water mark. In this manner, from the oxide film formed on the base material 1, the silica compound which causes the water mark is eluted in the liquid LQ. Therefore, as a countermeasure for suppressing the occurrence of the water mark, it is conceivable to suppress the elution of the silica compound in the liquid LQ. In other words, the occurrence of the water mark can be suppressed by reducing the elution amount of the silica compound in the liquid LQ and by lowering the concentration of the silica compound in the liquid LQ to be not more than an allowable concentration.

It is appreciated that it takes a predetermined time (for example, about 3 minutes) Tr after the substrate P (base material 1) and the liquid LQ come into contact with each other and the elution of the silica compound is started and before the concentration of the silica compound in the liquid LQ reaches not less than the allowable concentration. Namely, as the contact time during which the substrate P (base material 1) and the liquid LQ are contact with each other is longer, the elution amount of the silica compound eluted in the liquid LQ becomes greater and thus the concentration of the silica compound in the liquid LQ becomes higher. Therefore, by suppressing the contact time, during which the substrate P and the liquid LQ are contact with each other, to be not more than the predetermined time (allowable time) Tr, it is possible to prevent the silica compound, which causes the water mark, from being eluted in large amount in the liquid LQ.
Namely, by suppressing the liquid contact time Ta after the substrate P comes into contact with the liquid LQ, i.e. a time elapsed after the substrate P starts coming into contact with the liquid LQ is suppressed to not more than the predetermined time (allowable time) Tr, it is possible to lower the concentration of the silica compound in the liquid LQ to be not more than the allowable concentration. Therefore, when the liquid immersion area AR2 of the liquid LQ is formed on the substrate P, the formation of the water mark on the substrate P can be prevented by performing the process for removing the liquid LQ on the substrate P such that the liquid contact time Ta after the substrate P comes into contact with the liquid LQ in the liquid immersion area AR2 does not exceed the allowable time Tr.

The allowable time Tr can be obtained in advance through, for example, an experiment or simulation, and information about the obtained allowable time Tr is stored in advance in the controller CONT. The controller CONT performs various processes including the exposure and transport while managing, in accordance with the allowable time Tr, the liquid contact time Ta after the substrate P comes into contact with the liquid LQ in the liquid immersion area AR2. The exposure apparatus may include a memory for storing the information at the inside or outside of the controller CONT. Such a memory may store the allowable time Tr depending on the liquid LQ and the substrate (the kind of base material and a film (in particular, uppermost layer) to be formed on the base material) to be used. Such a memory may store a liquid contact time in which the allowable time Tr is considered depending on the liquid LQ and the substrate (base material and a film (in particular, uppermost layer) to be formed thereon) to be used.

There is a possibility that the time after the substrate P comes into contact with the liquid LQ and before the elution of the silica compound in the liquid LQ is started, and/or the elution amount of the silica compound eluted in the liquid LQ per unit time and/or the time after the substrate P comes into contact with the liquid LQ and before the concentration of the silica compound in the liquid LQ reaches the allowable concentration or higher change(s) depending on the liquid LQ and/or the substrate P (base material 1). Therefore, by setting the predetermined time Tr based on information about the liquid LQ and/or substrate P and by suppressing the liquid contact time Ta after the substrate P comes into contact with the liquid LQ to be not more than the allowable time Tr, it is possible to lower the concentration of the silica compound in the liquid LQ to be not more than the allowable concentration, and to prevent the water mark from forming on the substrate P.

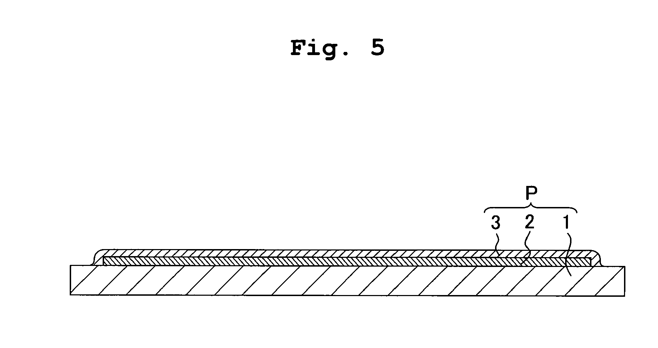

As shown in Fig. 5, when the substrate P has a protective film 3 called a topcoat film formed so as to cover a surface of the photosensitive material 2, there is a possibility that the elution of the silica compound from the base material 1 into the liquid LQ can be suppressed. In this case, the allowable time Tr can be set to be comparatively long. Thus, the allowable time Tr can be set based on information about the film formation (the laminated structure and a material forming, in particular, the uppermost layer) of the substrate P.

As described above, it is conceivable that the silica compound eluted in the liquid LQ is produced due to the oxide film (SiO₂) formed on the base material 1. Therefore, the formation of the oxide film can be reduced, for example, by lowering the oxygen concentration inside the chamber to thereby lower the oxygen concentration in the environment in which the substrate P is located, by locally lowering the oxygen concentration in the environment around the liquid immersion area AR2, and by reducing the dissolved oxygen amount in the liquid LQ to be supplied from the liquid supply mechanism 10.

In the exposure apparatus EX-SYS of this embodiment, examples of the impurities causing the water mark include the above-described "(1) a silica compound which is produced from silicon as the material forming the base material 1 and which is eluted in the liquid LQ in the liquid immersion area AR2" and "(2) a contaminant such as floating particles and/or a chemical substance in the atmosphere dispersed or dissolved in the liquid LQ in the liquid immersion area AR2". Therefore, by shortening the liquid contact time Ta after the substrate P comes into contact with the liquid LQ, it is possible to shorten the time during which the liquid LQ in contact with the substrate P is exposed to the atmosphere, and it is possible to reduce the dispersion or dissolving amount of contaminant in the atmosphere dispersing or dissolving into the liquid LQ, thereby making it possible to suppress the formation of the water mark caused by the above-described (2).

On the other hand, it is appreciated that the water mark is dry residue formed by the drying of the liquid containing impurity or impurities. After such a water mark is once formed due to the drying of the liquid containing impurities, it is very difficult to remove the water mark even by immersing the substrate in the liquid again or making the liquid flow on the substrate. In this embodiment, the liquid containing impurities which would otherwise cause the formation of water mark is prevented from drying on the substrate. Specifically, after the substrate P and the liquid LQ are brought into contact with each other (after the liquid immersion exposure of the substrate P is completed), the substrate P is transported to the cleaning device 100 without completely removing the liquid LQ on the substrate P, namely while the substrate is being left wet (in a wet state) and the process shifts to the cleaning process, and then the impurities causing the water mark and including silica compound and/or contaminants in the atmosphere are removed by the cleaning device 100, thereby suppressing the formation of water mark on the substrate P. The phrase "transport the substrate P to the cleaning device 100 in a wet state" means a state in which the liquid remains as a bulk or drops (droplets) on the substrate during the transport of the substrate P to an extent that the liquid does not dry and does not form any water mark on the substrate.

Impurities causing the water mark include, in addition to (1) and (2) described above, "(3) an adhered matter or body adhered to the substrate P" and "(4) an impurity contained in the liquid LQ supplied from the liquid supply mechanism 10". Therefore, before exposing the substrate P, the substrate P is cleaned by using the cleaning device provided in, for example, the coater/developer C/D-SYS or the exposure apparatus EX-SYS, thereby making it possible to suppress the occurrence of the water mark caused by the above-described (3). Further, by improving the quality (water quality) of the liquid LQ to be supplied from the liquid supply mechanism 10, the occurrence of water mark due to the above-described (4) can be suppressed.

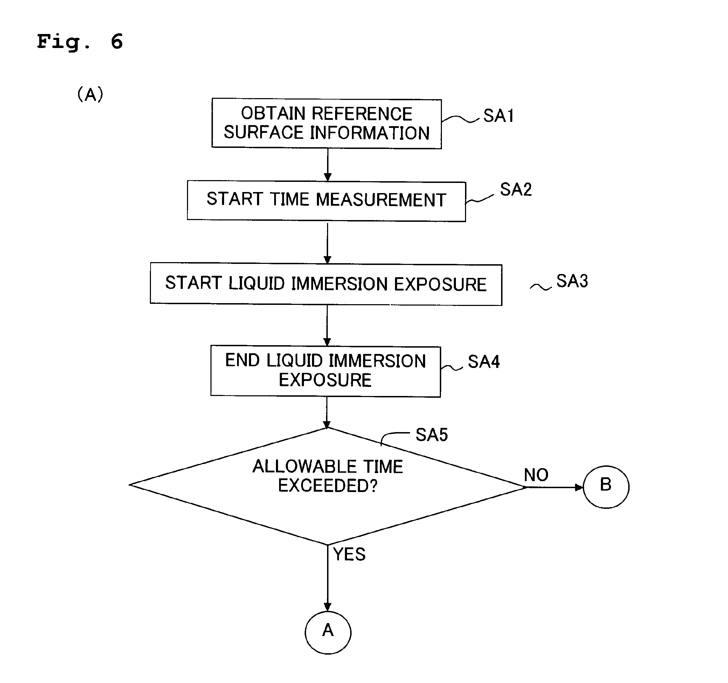

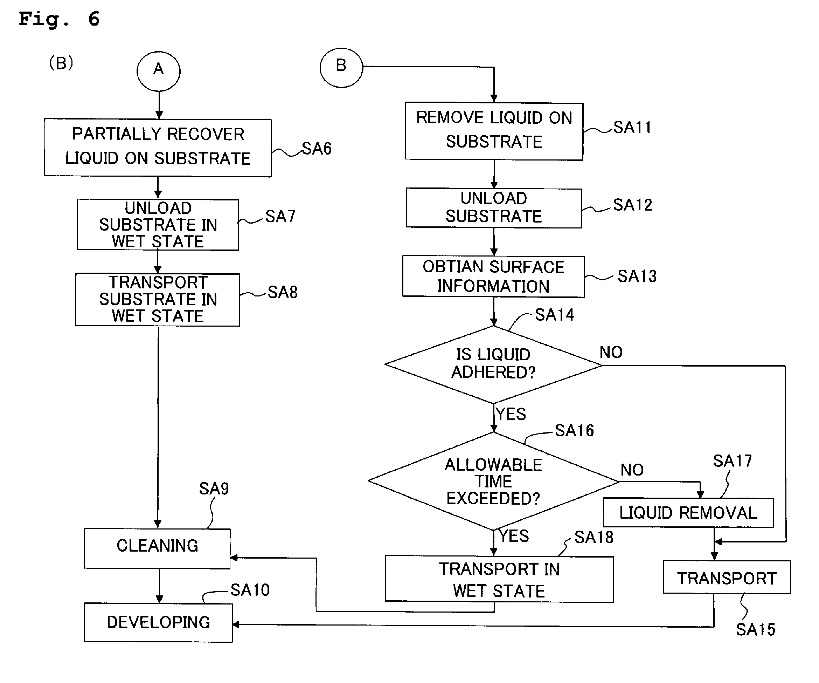

Next, an example of operations of the device producing system SYS including the above-described exposure apparatus-body EX will be explained with reference to the flowchart shown in Figs. 6(A) and 6(B).

When the substrate P before being exposed is transported from the coater/developer C/D-SYS to the pre-alignment unit of the exposure apparatus EX-SYS, the controller CONT roughly aligns the substrate P to be roughly positioned with the substrate stage PST in the pre-alignment unit. The controller CONT obtains surface information of the substrate P before being exposed by using the imaging device 80. The liquid LQ is not adhered to the surface of the substrate P before the exposure, and the controller CONT stores surface information of the substrate P which has not been exposed yet and to which the liquid LQ is not adhered as a reference surface information (reference image information) (Step SA1).

Next, the controller CONT loads the substrate P onto the substrate holder PH of the exposure apparatus-body EX by the first transport arm H1. The substrate P is held on the substrate holder PH. Then, the controller CONT starts the supply operation for supplying the liquid LQ by the liquid supply mechanism 10 and the recovery operation for recovering the liquid by the liquid recovery mechanism 20 so as to form the liquid immersion area AR2 of the liquid LQ on the substrate P held on the substrate holder PH. The controller CONT starts time measurement by a timer 7 by setting a point of time, when the substrate P and the liquid LQ for forming the liquid immersion area AR2 come into contact with each other for the first time, as a measurement start time-point To (Step SA2).

In this embodiment, the controller CONT starts the supply operation for supplying the liquid LQ onto the substrate P by the liquid supply mechanism 10, and starts time measurement by the timer 7 by setting the point of time when the liquid LQ supplied from the liquid supply mechanism 10 comes into contact with the substrate P for the first time as the measurement start time-point To. In this case, for example, a liquid sensor capable of detecting the liquid LQ is provided in the vicinity of the supply ports 12 of the nozzle member 70, and the controller CONT can start the time measurement by the timer 7 based on the detection result of the liquid sensor. Namely, the point of time when the liquid sensor provided in the vicinity of the supply ports 12 detects the liquid LQ for the first time and the point of time when the liquid LQ supplied from the supply ports 12 comes into contact with the substrate P for the first time are almost simultaneous. Therefore, the controller CONT can regard the point of time when the liquid sensor detects the liquid LQ for the first time as the point of time when the substrate P and the liquid LQ come into contact with each other for the first time. Alternatively, the time measurement may be started at the point of the time when the controller CONT transmits to the liquid supply mechanism 10 a signal for starting the supply of the liquid LQ. In this case, by obtaining in advance a time necessary after such a signal is transmitted and before the liquid comes into contact with the substrate P and by subtracting the necessary time from the point of time at which the measurement is started, it is possible to obtain a real measurement start time-point To without using the liquid sensor.

Alternatively, it is allowable that, after forming the liquid immersion area AR2 of the liquid LQ between the upper surface 47 of the substrate stage PST and the projection optical system PL, the controller CONT starts the time measurement by the timer 7 by setting a point of time, when the liquid immersion area AR2 is arranged on the substrate P for the first time by moving the substrate stage PST in the XY directions, as the measurement start time-point To. In this case, the controller CONT judges whether or not the liquid immersion area AR2 has been arranged on the substrate P, namely whether or not the substrate P and the liquid LQ have come into contact with each other, based on the measurement result of the laser interferometer 44 which measures the position of the substrate stage PST in the XY directions, and the controller CONT can start the time measurement by the timer 7.

After forming the liquid immersion area AR2 of the liquid LQ on the substrate P, the controller CONT starts the liquid immersion exposure of the substrate P (step SA3). The controller CONT makes the exposure light beam EL to be emitted from the illumination optical system IL and makes the mask M held on the mask stage MST illuminated by the exposure light beam EL. The exposure light beam EL passed through the mask M is irradiated onto the substrate P held on the substrate holder PH via the projection optical system PL and the liquid LQ in the liquid immersion area AR2, thereby subjecting the substrate P to the liquid immersion exposure process.

A plurality of shot areas are defined on the substrate P, and after the exposure for one shot area is completed, the next shot area is moved to the scanning start position by the stepping movement of the substrate P, and thereafter, the scanning exposure is successively performed for each of the shot areas while moving the substrate P in the step-and-scan manner.

After the liquid immersion exposure for each of the shot areas is ended (Step SA4), the controller CONT stops the supply of the liquid onto the substrate P by the liquid supply mechanism 10 and judges, based on the measurement result of the timer 7, whether or not the time elapsed after the measurement start time-point To has exceeded the allowable time Tr, namely whether or not the liquid contact time Ta after the substrate P comes into contact with the liquid LQ in the liquid immersion area AR2 has exceeded the allowable time Tr (Step SA5).

For example, when the exposure apparatus EX-SYS successively exposes a plurality of lots of the substrates P, the exposure condition (process condition) is made different among the lots in some cases. For example, when the exposure time (consequently, liquid contact time Ta) per one substrate P is different among the lots, there is a possibility a lot (substrate P) for which liquid contact time Ta is less than the allowable time Tr and a lot (substrate P) for which liquid contact time Ta is not less than the allowable time Tr are present in a mixed manner. In such a case, the controller CONT manages the liquid contact times Ta and judges whether or not the liquid contact time Ta has exceeded the allowable time Tr each time the exposure is completed for each of the substrates P.

In Step SA5, when the controller CONT judges that the liquid contact time Ta after the substrate P came into contact with the liquid LQ in the liquid immersion area AR2 has exceeded the allowable time Tr, then the controller CONT partially recovers the liquid LQ forming the liquid immersion area AR2 on the substrate P by using the liquid recovery mechanism 20 so that a part of the liquid LQ remains on the substrate P, namely the substrate P is maintained in a wet state (Step SA6). Here, by maintaining the substrate P in a wet state, it is possible to prevent the formation of water mark due to the liquid remaining on the substrate P which would be otherwise dried immediately after the recovery of the liquid LQ. At least until the process of Step SA9 or Step SA17 which will be described later on, it is desirable that the liquid remains on the substrate P to an extent that the liquid remaining on the substrate P does not dry and does not form any water mark.

In Step SA6, the controller CONT recovers the liquid LQ on the substrate P by using the liquid recovery mechanism 20, and then unloads the substrate P from the substrate holder PH by using the second transport arm H2. The second transport arm H2 unloads the substrate P from the substrate holder PH in the state that the substrate is wet (Step SA7).

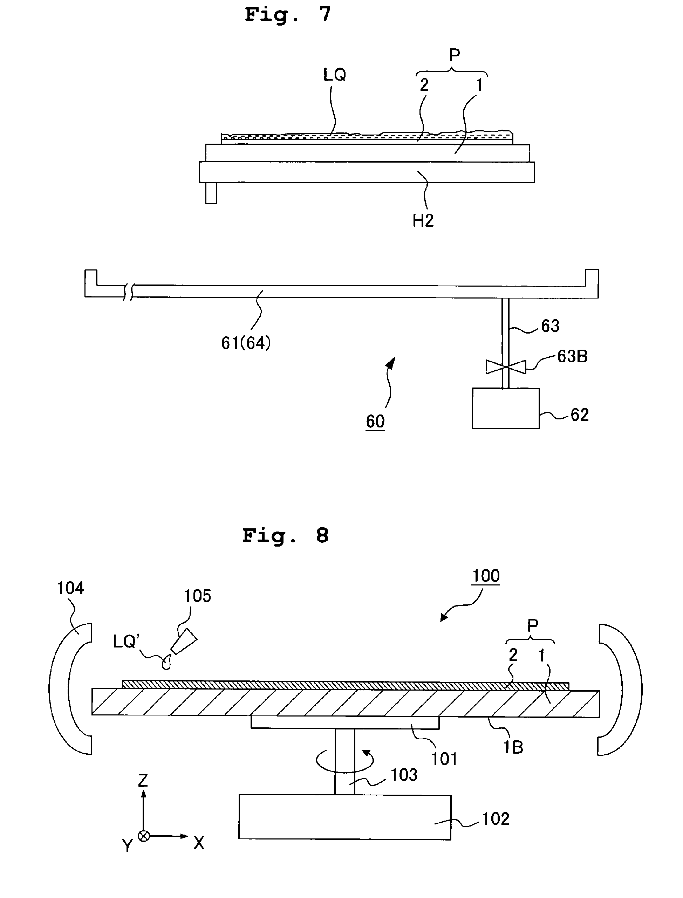

As shown in Fig. 7, the second transport arm H2 transports the substrate P in a wet state. The controller CONT transports the substrate P to the coater/developer C/D-SYS via the interface IF, in the state that the substrate is wet, by using the second transport arm H2 without performing the liquid removing operation in the liquid removing system 90 (Step SA8). It is also allowable that the controller CONT delivers the substrate P in the wet state from the second transport arm H2 to the fourth transport arm H4, and transports the substrate P by the fourth transport arm H4 to the coater/developer C/D-SYS via the interface IF. There is a possibility that, during the transport by the second transport arm H2 (or the fourth transport arm H4) of the exposed substrate P to which the liquid LQ is adhered, the liquid LQ falls from the substrate P. However, the fallen liquid LQ can be recovered by the gutter member 61 (or 64). By recovering the fallen liquid LQ by the gutter member 61, it is possible to prevent the problem such as the scattering of the liquid LQ around the transport path.

Here, after unloading the substrate P from the substrate holder PH, the controller CONT may obtain surface information by making by the imaging device 80 observe the surface of the substrate P after the substrate P has been exposed. The controller CONT can confirm whether or not the liquid LQ is adhered to the surface of the substrate P (whether or not that the substrate P is wet), based on the imaging result of the imaging device 80 and the reference surface information obtained in Step SA1. Since the imaging state when the liquid LQ is adhered to the surface of the substrate P and the imaging state when the liquid LQ is not adhered are different from each other, the controller CONT can observe whether or not the liquid LQ is adhered, namely whether or not the substrate P is wet by comparing the reference surface information of the substrate P before being exposed obtained in Step SA1 and the surface information of the substrate P after being exposed. When the substrate P is not wet for any reason, a liquid supply device capable of supplying the liquid LQ to the substrate P is provided on, for example, the transport path of the transport system H, and the substrate P can be wetted by supplying the liquid LQ to the substrate P by, for example, blowing the liquid LQ with the liquid supply device.

The controller CONT can also confirm, by using the focus/leveling-detecting system 30, whether or not the substrate P before being unloaded from the substrate holder PH is wet. Since a light receiving state of the light receiver 32 of the focus/leveling-detecting system 30 when the liquid LQ is adhered to the surface of the substrate P and a light receiving state when the liquid is not adhered are different from each other, the controller CONT can confirm whether or not the substrate P is wet based on the light receiving results of the light receiver 32.

Then, the substrate P unloaded from the substrate holder PH is transported to the cleaning device 100 of the coater/developer C/D-SYS, and the cleaning device 100 performs cleaning of the transported substrate P (Step SA9). As described above, the cleaning device 100 may be provided in the exposure apparatus EX-SYS.

Fig. 8 is a drawing showing the cleaning device 100. In Fig. 8, the cleaning device 100 includes a holder 101 which holds the central portion of the lower surface of the substrate P (lower surface 1B of the base material 1), a shaft 103 connected to the holder 101, a rotation mechanism 102 which rotates the holder 101 holding the substrate P via the shaft 103, a ring-shaped member 104 provided so as to surround the substrate P held on the holder 101 to prevent the scattering of the liquid, and a supply member 105 which supplies a cleaning liquid LQ' onto the substrate P. In this embodiment, the cleaning liquid LQ' and the liquid LQ in the liquid immersion area AR2 are a same liquid (pure or purified water). In the upper surface of the holder 101, a vacuum attraction hole forming a part of a vacuum device is formed, and the holder 101 attracts and holds the central portion of the lower surface of the substrate P. The rotation mechanism 102 includes an actuator such as a motor, and rotates the substrate P held on the holder 101 in the θZ direction by rotating the shaft 103 connected to the holder 101. The supply member 105 is arranged at a position above or over the substrate P held on the holder 101, and supplies the cleaning liquid LQ' to the upper surface of the substrate P from the position above or over the substrate P. The supply member 105 is movable in the X-axis, Y-axis, Z-axis, θX, θY, and θZ directions by an unillustrated drive mechanism. That is, the supply member 105 is relatively movable with respect to the substrate P held on the holder 101. The cleaning device 100 can move the supply member 105 relative to the substrate P to thereby adjust a direction in which the cleaning liquid LQ' is supplied to the substrate P (supplying direction of the cleaning liquid LQ'), the distance between the supply member 105 and the substrate P, and the like. The cleaning device 100 supplies the cleaning liquid LQ' onto the substrate P held on the holder 101 from the supply member 105 and cleans the substrate P with the cleaning liquid LQ'. In this embodiment, the cleaning device 100 continuously supplies the cleaning liquid LQ' from the supply member 105 while rotating the substrate P held on the holder 101 in the θZ direction in the drawing by the rotation mechanism 102 and moving the supply member 105 relative to the substrate P held on the holder 101. By doing so, the cleaning liquid LQ' is supplied to a wide area of the upper surface of the substrate P. Accordingly, the cleaning device 100 can clean the wide area on the substrate P with the cleaning liquid LQ'. Further, since the ring-shaped member 104 is provided around the substrate P held on the holder 101, it is possible to prevent the cleaning liquid LQ' can be prevented by the ring-shaped member 104.

After the substrate P is cleaned in the cleaning device 100, the cleaning liquid LQ' is removed by, for example, stopping the supply of the cleaning liquid LQ' and by rotating the shaft 103. Afterwards, the substrate P is transported to the coater/developer-body C/D and subjected to the developing (Step SA10). In the substrate P, the occurrence of the water mark is suppressed, and thus the substrate is satisfactorily developed without any developing failure or defect.

As described above, the substrate P with the exceeded the allowable time Tr is transported to the cleaning device 100 in the state that the substrate P is wet, thereby making it possible to suppress the occurrence of the water mark. Further, since the substrate P is transported to the cleaning device 100 while the substrate is left to be wet and is subjected to the cleaning to wash or clean away the liquid LQ including impurities causing the water mark, thereby making it possible to suppress formation of water mark on the substrate P.

In Step SA5, when the controller CONT judges that the liquid contact time Ta of the substrate P after the substrate P comes into contact with the liquid LQ in the liquid immersion area AR2 does not exceed the allowable time Tr, then the controller CONT uses the liquid recovery mechanism 20 to sufficiently remove the liquid LQ in the liquid immersion area AR2 on the substrate P held on the substrate holder PH (Step SA11).

After sufficiently removing the liquid LQ on the substrate P by using the liquid recovery mechanism 20, the controller CONT unloads the substrate P from the substrate holder PH by using the second transport arm H2 (Step SA12).

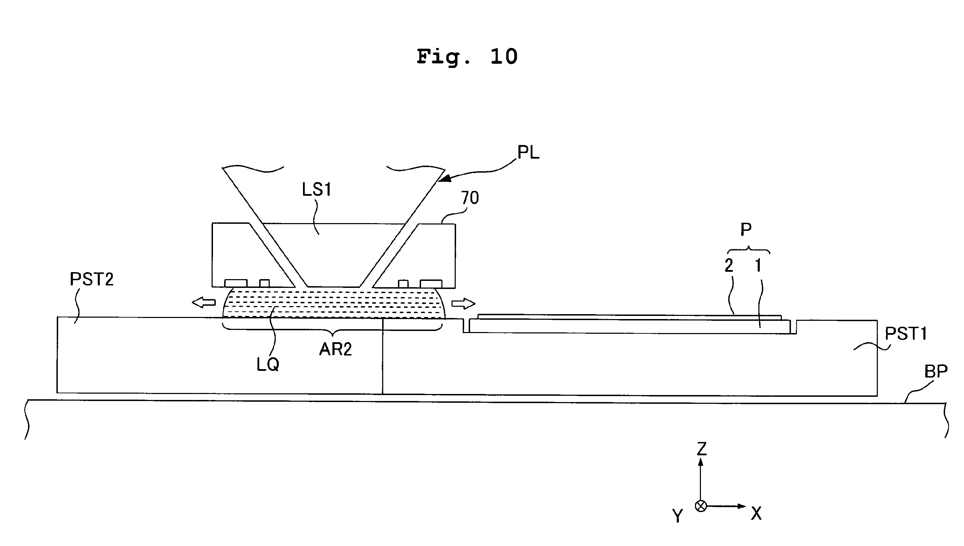

Here, the phrase "remove the liquid immersion area AR2 on the substrate P" means not only recovering the liquid LQ from the surface of the substrate P by using the liquid recovery mechanism 20 as described above, but also moving the liquid from the surface of the substrate P only with the movement of the liquid LQ due to the action of the gravity by, for example, inclining the substrate P, or the like. Alternatively, the phrase also includes a case in which the liquid immersion area AR2 is moved from the surface of the substrate P onto another object. For example, the phrase includes a case in which the substrate stage PST is moved so as to move the liquid immersion area AR2 from the surface of the substrate P onto the substrate stage PST (upper surface 47), and a case in which, as shown in Fig. 10, the liquid immersion area AR2 formed on the substrate P is moved onto a measuring stage PST2. Namely, in order to "remove the liquid immersion area AR2 on the substrate P", arbitrary method and an arbitrary mechanism which performs the method can be used. Here, the measuring stage PST2 is a stage which does not hold the substrate P, and is provided with various measuring instruments or devices which perform measurements concerning the exposure process, such as an illuminance unevenness sensor as disclosed in Japanese Patent Application Laid-open No. 57-117238 and an irradiance sensor (illuminance sensor) as disclosed in Japanese Patent Application Laid-open No. 11-16816. By moving the substrate stage PST1 and the measuring stage PST2 together in the XY directions in a state that the substrate stage PST1 and the measuring stage PST2 are close to each other or in contact with each other, it is possible to move the liquid immersion area AR2 formed on the side of the image plane of the projection optical system PL between the surface of the substrate stage PST1 and the surface of the measuring stage PST2.

After unloading the substrate P from the substrate holder PH, the controller CONT observes the surface of the substrate P after being exposed by the imaging device 80 to obtain the surface information (Step SA13). Then, the controller CONT confirms that the liquid LQ is not adhered to the surface of the substrate P (judges whether or not the liquid is adhered to the surface of the substrate P), based on the imaging result of the imaging device 80 and the reference surface information obtained in Step SA1 (Step SA14). Namely, also in a case that the liquid LQ on the substrate P is removed by using the liquid recovery mechanism 20 before the substrate P is unloaded from the substrate holder PH, there is a possibility that the liquid LQ remains on the substrate P. Therefore, the controller CONT judges whether or not the liquid LQ is adhered to (remaining on) the surface of the substrate P, based on imaging information of the imaging device 80. In this case also, the controller CONT can confirm, by using the focus/leveling-detecting system 30, whether or not the liquid LQ is adhered to the substrate P before the substrate P is unloaded from the substrate holder PH.

In Step SA14, when the controller CONT judges that the liquid LQ is not adhered onto the substrate P, the controller CONT uses the second transport arm H2 to transport the substrate P, to which the liquid LQ is not adhered, to the coater/developer C/D-SYS via the interface IF (Step SA15). It is also allowable that the controller CONT delivers the substrate P to which the liquid LQ is not adhered (the substrate which is not wet) from the second transport arm H2 to the third transport arm H3, and transports the substrate by the third transport arm H3 to the coater/developer C/D-SYS via the interface IF. The substrate P transported to the coater/developer C/D-SYS is subjected to the developing process (Step SA10).

On the other hand, when the controller CONT judges in Step SA14 that the liquid LQ is adhered onto the substrate P, then the controller CONT judges, based on the measurement result of the timer 7, whether or not the elapsed time elapsed after the measurement start time-point To has exceeded the predetermined allowable time Tr, namely whether or not the liquid contact time Ta after the substrate P comes into contact with the liquid LQ in the liquid immersion area AR2 has exceeded the allowable time Tr (Step SA16).

In this case, the liquid contact time Ta includes a time after the measurement start time-point To and before the operation for removing the liquid immersion area AR2 is performed (completed) and a time during which the liquid LQ remains on the substrate P after the liquid immersion area AR2 has been removed on the substrate P. In Step SA14, the controller CONT judges whether or not the liquid LQ remaining on the surface of the substrate P is to be removed, depending on the liquid contact time Ta which includes the time during which the liquid LQ remains on the substrate P after the liquid immersion area AR2 has been removed on the substrate P.

In Step SA16, when the controller CONT judges that the liquid contact time Ta has not exceeded the allowable time Tr, the controller CONT executes the operation for removing the liquid LQ remaining on the substrate P by using the liquid removing system 90 (Step SA17).

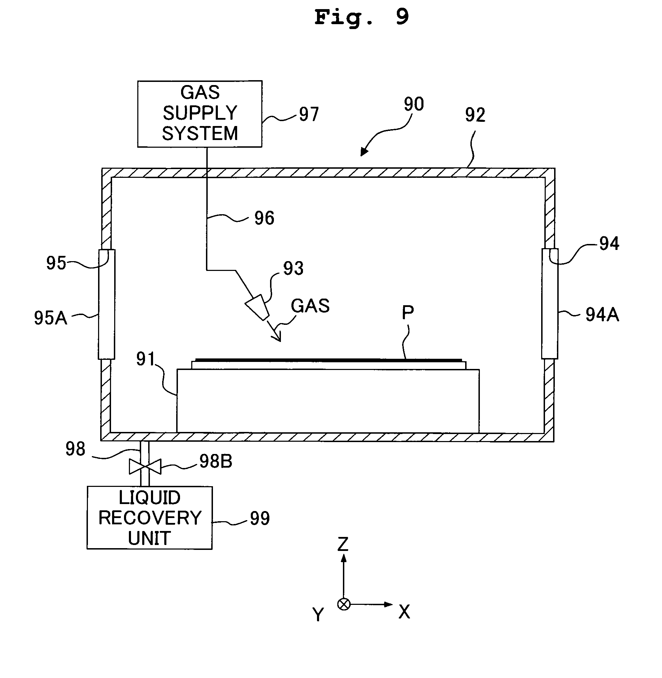

Fig. 9 is a diagram showing the liquid removing system 90. The liquid removing system 90 performs the operation for removing the liquid LQ on the substrate P after the substrate P is unloaded from the substrate holder PH, and the liquid removing system 90 includes a holder table 91 capable of holding the substrate P, a cover member 92 for accommodating the holder table 91, and a blow nozzle 93 which blows a gas to the substrate P held on the holding table 91. In the cover member 92, first and second openings 94 and 95 are formed; and the first and second openings 94 and 95 are provided with shutters 94A and 95A respectively. The second transport arm H2 while holding the substrate P after being subjected to the liquid immersion exposure enters from the first opening 94 to the inside of the cover member 92 accommodating the holder table 91. At this time, the controller CONT drives the shutter 94A to open the first opening 94. On the other hand, the second opening 95 is closed by the shutter 95A. Then, a blow nozzle (not shown in the drawing) blows a gas to the back surface of the substrate P to remove the liquid adhered to the back surface of the substrate P. Next, the second transport arm H2 delivers the substrate P to the holder table 91. The holder table 91 vacuum-attracts and holds the delivered substrate P. The blow nozzle 93 forming a part of the liquid removing system 90 is arranged inside the cover member 92, and a gas supply system 97 is connected to the blow nozzle 93 via a flow channel 96. In the flow channel 96, a filter is provided to remove a foreign matter (dust and/or oil mist) from the gas to be blown to the substrate P. By driving the gas supply system 97, a predetermined gas is blown onto the surface of the substrate P from the blow nozzle 93 through the flow channel 96, to blow away and remove the liquid LQ adhered to the surface of the substrate P by the blown gas. A liquid recovery unit 99 is connected to the cover member 92 via a recovery tube 98. The recovery tube 98 is provided with a valve 98B which opens/closes the flow channel in the recovery tube 98. The liquid LQ scattered away from the substrate P is recovered by the liquid recovery unit 99 connected to the cover member 92. The liquid recovery unit 99 recovers the liquid LQ scattered away from the substrate P by sucking the gas inside the cover member 92 together with the scattered liquid LQ. Here, the liquid recovery unit 99 continuously performs the operation for sucking the gas and the scattered liquid LQ inside the cover member 92. With this, the liquid LQ is prevented from remaining inside the cover member 92 including the inner wall and the bottom of the cover member 92, thereby preventing the humidity inside the cover member 92 from greatly fluctuating or varying. Also, when the shutters 94A and 95A are opened, the moist gas inside the cover member 92 does not outflow to the outside of the cover member 92.

After the controller CONT removes the liquid LQ on the substrate P by the liquid removing system 90, the controller CONT unloads the substrate P from the liquid removing system 90 by using the third transport arm H3.
The third transport arm H3 enters from the second opening 95 to the inside of the cover member 92 which accommodates the holder table 91. At this time, the controller CONT drives the shutter 95A to open the second opening 95. On the other hand, the first opening 94 is closed by the shutter 94A. Then, the third transport arm H3 unloads the substrate P from the holder table 91 and takes the substrate P to the outside of the cover member 92.

The controller CONT transports the substrate P, subjected to the liquid removal process in the liquid removing system 90, to the coater/developer C/D-SYS via the interface IF by using the third transport arm H3 (Step SA15). The transported substrate P is developed by the coater/developer-body C/D (Step SA10).

Here, before the controller CONT transports the substrate P subjected to the liquid removal process in the liquid removing system 90 to the interface IF, the controller CONT can obtain surface information of the substrate P subjected to the liquid removing process. The controller CONT can judge whether or not the liquid LQ has been completely removed from the surface of the substrate P, based on the imaging result of the imaging device 80 and the reference surface information obtained in Step SA1. Then, when the controller CONT judges that the liquid LQ is adhered to the substrate and that the allowable time Tr has not been exceeded yet, the controller CONT can execute the liquid removing operation again to remove the liquid on the substrate P by using the liquid removing system 90.

On the other hand, when the controller CONT judges in Step SA16 that the liquid contact time Ta has exceeded the allowable time Tr, the controller CONT transports the substrate P to the coater/developer C/D-SYS via the interface IF while leaving the substrate in the wet state, without performing the liquid removing operation by the liquid removing system 90 (Step SA18). The transported substrate P is subjected to the cleaning by the cleaning device 100 (Step SA9), and afterwards the substrate P is subjected to the developing by the coater/developer-body C/D (Step SA10).

In Step SA5, it is desirable that the controller CONT judges whether or not the liquid contact time Ta exceeds the allowable time Tr by adding a time necessary for the liquid removal of Step SA11 to the liquid contact time Ta. Similarly, in Step SA16, it is desirable that the controller CONT judges whether or not the liquid contact time exceeds the allowable time by also adding a time required before the liquid removing operation of the liquid removing system 90 is started.

The imaging device 80 may be omitted in the above-described embodiment. Namely, in the flowchart shown in Figs. 6(A) and 6(B), it is allowable that Steps SA1, SA13, SA14, and SA16 to SA18 are omitted, and that the substrate P is transported to the coater/developer C/D-SYS via the interface IF after being unloaded from the substrate stage PST and then immediately developed.

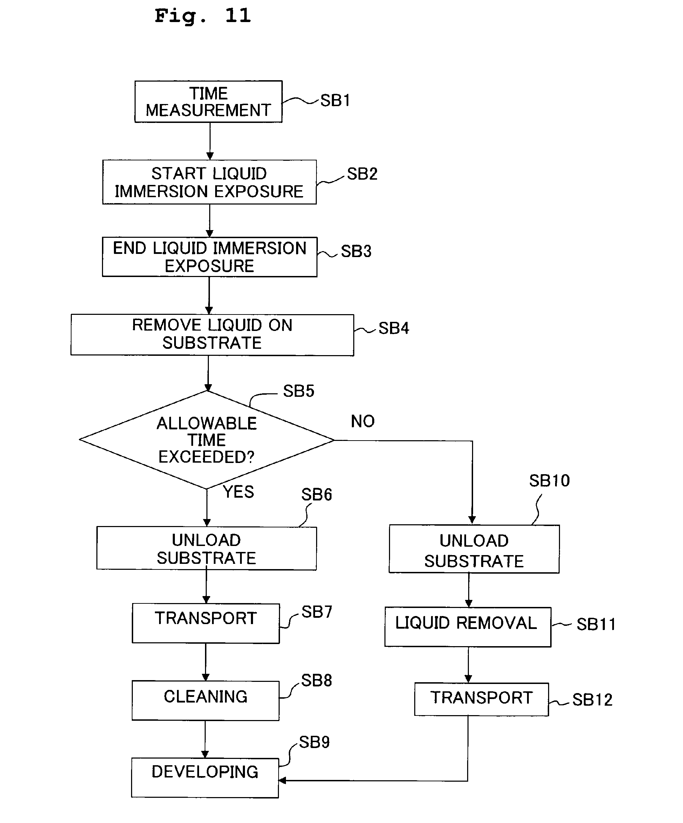

When it is considered that only the recovery of the liquid LQ by the liquid recovery mechanism 20 is not sufficient, then the substrate P unloaded from the substrate stage PST may be transported to the liquid removing system 90. Fig. 11 is a flowchart showing an example of the transport of the substrate P unloaded from the substrate stage PST to the liquid removing system 90. It should be noted that the flowchart of Fig. 11 also shows operations in which the imaging device 80 is omitted.

The controller CONT loads the substrate P onto the substrate holder PH by the first transport arm H1, and starts the operation for supplying the liquid LQ by the liquid supply mechanism 10 and the operation for recovering the liquid LQ by the liquid recovery mechanism 20 to thereby form the liquid immersion area AR2 of the liquid LQ on the substrate P held on the substrate holder PH. Then, the controller CONT starts time measurement by the timer 7 by setting the time, when the substrate P and the liquid LQ come into contact with each other for forming the liquid immersion area AR2, as a measurement start time-point To (Step SB1).

After the liquid immersion area AR2 of the liquid LQ is formed on the substrate P, the controller CONT starts the liquid immersion exposure of the substrate P (Step SB2). After ending or completing the liquid immersion exposure for each of the shot areas (Step SB3), the controller CONT stops the supply of the liquid onto the substrate P by the liquid immersion supply mechanism 10 and removes the liquid LQ in the liquid immersion area AR2 on the substrate P by using the liquid recovery mechanism 20 (Step SB4).

In this case, it is also allowable that the liquid immersion area AR2 is only moved from the substrate P onto another object such as the substrate stage PST.

Next, the controller CONT judges based on the measurement result of the timer 7 whether or not the elapsed time, elapsed after the substrate P is unloaded from the substrate stage PST (substrate holder PH) and transported to the liquid removing system 90 and before the liquid removing operation is started, exceeds the allowable time Tr (Step SB5). Here, the controller CONT makes judgment of Step SB5 by regarding the time after the transport to the liquid removing system 90 and before the start of the liquid removing operation, as a part of the liquid contact time Ta. This is because there is a possibility that, even after the liquid is removed on the substrate P by the liquid recovery mechanism 20, a part of the liquid LQ remains on the substrate P, and that the liquid LQ is in contact with the substrate P until the liquid removing operation is performed by the liquid removing system 90. In Step SB5, when the controller judges that the liquid contact time Ta exceeds the allowable time Tr, the controller CONT unloads the substrate P from the substrate holder PH by using the second transport arm H2 (Step SB6). The second transport arm H2 transports the substrate P to the cleaning device 100 of the coater/developer C/D-SYS via the interface IF without performing the liquid removing operation in the liquid removing system 90 (Step SB7). The coater/developer C/D-SYS washes away (cleans away) the liquid LQ containing impurities that may be adhered to the substrate P transported to the cleaning device 100, in the same manner as described above (Step SB8), then transports the substrate P after being cleaned to the coater/developer-body C/D, and then performs the developing process (Step SB9).

Also in Step SB5, when the controller CONT judges that the liquid contact time Ta does not exceed the allowable time Tr, the controller CONT unloads the substrate P from the substrate holder PH by using the second transport arm H2 (Step SB10), and transports the substrate to the liquid removing system and executes the liquid removing operation for the substrate P in the same manner as described above (Step SB11). After removing the liquid on the substrate P by the liquid removing system 90, the controller CONT unloads the substrate P from the liquid removing system 90 by using the third transport arm H3.
The third transport system H3 transports the substrate P, subjected to the liquid removal process, to the coater/developer C/D-SYS via the interface IF (Step SB12). The substrate P transported to the coater/developer C/D-SYS is subjected to the developing process, without subjected to the cleaning process in the cleaning device 100 (Step SB9).

As described above, in the operations shown in the flowchart of Fig. 11, when it is judged that the liquid removal process can be started by the liquid removing system 90 before the liquid contact time Ta exceeds the predetermined allowable time Tr, the substrate P feared to be adhered with the liquid, to which the pollutants may enter and mix therewith, is subjected to the liquid removal process by the liquid removing system 90, thereby making it possible to prevent the occurrence of the water mark. On the other hand, when it is judged that the liquid contact time Ta exceeds the allowable time Tr before starting the liquid removal process, the substrate P is immediately transported to the cleaning device 100 and the substrate P, feared to be adhered with the liquid to which the pollutants may enter to mix therewith, is cleaned, thereby making it possible to prevent the occurrence of the water mark, similarly to the example case shown in Figs. 6(A) and 6(B).

In some case, an error which requires to stop the exposure operation occurs for any reason during the liquid immersion exposure (Step SA3) of the substrate P. When such an error occurs (when an error signal is detected), in some cases, the controller CONT unloads the substrate P from the substrate stage PST and retreats the substrate to a predetermined retreat position. When the liquid contact time Ta of the substrate P in which the error occurs does not exceed the predetermined allowable time Tr, the controller CONT performs at least one of the liquid recovery process by the liquid recovery mechanism 20 and the liquid removal process by the liquid removing system 90 and then transports the substrate P in which the error occurs to the predetermined retreat position. On the other hand, when the liquid contact time Ta of the substrate P in which the error occurs exceeds the predetermined allowable time Tr, the controller immediately transports the substrate P in which the error occurs to the cleaning device 100, and after performing the cleaning process, the controller transports the substrate to the predetermined retreat position. By doing so, it is possible to prevent the occurrence of the water mark on the substrate P in which the error occurs.

In the above-described embodiment, the controller CONT performs various processes including the exposure and the transport while managing the liquid contact time Ta after the substrate P comes into contact with the liquid LQ in the liquid immersion area LQ, in accordance with the predetermined allowable time Tr. However, it is allowable that the controller CONT performs the various processes while managing a time Tb after removing the liquid immersion area AR on the substrate P. Here, the phrase "remove the liquid immersion area AR2 on the substrate P" includes not only recovering the liquid LQ on the substrate P by using the liquid recovery mechanism 20, but also moving the liquid from the surface of the substrate P only with the movement of the liquid LQ due to for example, the action of gravity by inclining the substrate P, without using the liquid recovery mechanism 20. Alternatively, the phrase includes also a case in which the liquid immersion area AR2 is moved from the surface of the substrate P onto another object. For example, the phrase includes a case in which the substrate stage PST is moved to thereby move the liquid immersion area AR2 from the surface of the substrate P onto the substrate stage PST, or a case in which, as shown in Fig. 10, the liquid immersion area AR2 formed on the substrate P is moved onto the measuring stage PST2. Namely, in order to "remove the liquid immersion area AR2 on the substrate P", any method and any mechanism which performs the method can be used. Here, the measuring stage PST2 is a stage which does not hold the substrate P, and which is provided with various measuring instruments for performing measurements relating to the exposure process, such as an illuminance unevenness sensor as disclosed in Japanese Patent Application Laid-open No. 57-117238, and an irradiance sensor (illuminance sensor) as disclosed in Japanese Patent Application Laid-open No. 11-16816. By moving the substrate stage PST1 and the measuring stage PST2 in the XY directions together in a state that he substrate stage PST1 and the measuring stage PST2 are close to each other or in contact with each other, the liquid immersion area AR2 formed on the side of the image plane of the projection optical system PL can be moved between the surface of the substrate stage PST1 and the surface of the measuring stage PST2.

The state after the liquid immersion area AR is removed on the substrate P includes a state that the liquid LQ remains on the substrate P (there is a possibility that, even after the liquid immersion area AR2 has been moved or removed from the surface of the substrate P, the liquid LQ remains on the substrate P as, for example, drops or droplets). If the liquid removing operation by the liquid removing system 90 is completed before the remaining liquid LQ dries on the substrate P, then the occurrence of water mark can be prevented. Therefore, with the time when the operation for removing the liquid immersion area AR2 on the substrate P is performed (completed) being regarded as a measurement start time-point T₁, it is judged whether or not an elapsed time elapsed after the measurement start time-point T₁, namely a time Tb after the liquid immersion area AR2 is removed on the substrate P and before the liquid removal process in the liquid removing system 90 is started, exceeds a predetermined allowable time Tr'; and when it is judged that the time Tb after the liquid immersion area AR2 is removed on the substrate P does not exceed the allowable time Tr', then the liquid removal process of the liquid LQ remaining on the substrate P is executed, thereby preventing the occurrence of water mark more reliably.

On the other hand, when it is judged that the time Tb after the liquid immersion area AR2 is removed on the substrate P exceeds the allowable time Tr', then the substrate P is immediately transported to the cleaning device 100, without performing the liquid removal process in the liquid removing system 90, and the substrate is subjected to the cleaning, thereby making it possible to prevent the occurrence of water mark.

It is possible to regard the time, after the liquid immersion area AR2 is removed on the substrate P and the substrate P is unloaded from the substrate stage PST and before the liquid removal process in the liquid removing system 90 is started, to be almost constant. However, the remaining amount of the liquid LQ and the distribution of the liquid LQ on the substrate P change or vary depending on the surface state of the substrate P. Therefore, there is a need to change the allowable time Tr' for each of the substrates or for each of the substrate lots. For example, when a contact angle (including a dynamic contact angle) on the surface of the substrate P with respect to the liquid LQ is small, a large amount of liquid LQ remains on the substrate P and spreads on and wets the substrate P. Since the time required until such a large amount of remaining liquid LQ dries is long, the allowable time Tr' can also be set to be long. On the contrary, when the contact angle of the liquid LQ on the surface of the substrate P is great (for example, not less than 100 degrees), the liquid LQ remains on the substrate to an extent that the liquid LQ remains on the substrate P as small drops or droplets. Since the time required until such a small amount of the remaining liquid dries is very short, it is necessary that the allowable time Tr' is also set to be short. Alternatively, as will be described later, it is also possible to adjust the allowable time by properly selecting the combination of the liquid and the material forming the surface of the substrate. Similarly to the substrate P shown in Fig. 2, when the film on the substrate P is removed at the peripheral edge portion of the substrate, there is a possibility that fine or minute droplets remain in the vicinity of the central portion of the substrate P and a large amount of the liquid remains on (adhere to) the peripheral edge portion of the substrate P. In this case, it is necessary to set the allowable time Tr' depending on the surface state in the vicinity of the central portion of the substrate P at which the remaining liquid is considered to dry quickly. Since the surface state of the substrate P and the time required until the liquid remaining on the substrate P dries can be obtained in advance through an experiment and/or simulation, the allowable time Tr' for a substrate P to be exposed next can be determined by storing a table and/or function for determining the allowable time Tr' from the surface state of the substrate P in the controller CONT, and then by obtaining, in advance, information about the substrate P to be exposed next (the contact angle on the surface of the substrate P with respect to the liquid LQ, the presence or absence of film, etc.).

Thus, the liquid removal process is performed by the liquid removing system 90 before the elapsed time Tb elapsed after the liquid immersion area AR2 is removed on the substrate P exceeds the predetermined allowable time Tr', and when the elapsed time Tb exceeds the predetermined time Tr', the polluted liquid that might be adhered to the substrate P is cleaned without performing the liquid removal process, thereby making it possible to prevent the occurrence of the water mark.

Further, in a case that an error occurs during the exposure of the substrate P, when the elapsed time Tb after the liquid immersion area AR2 is removed on the substrate P in which the error is caused does not exceed the predetermined allowable time Tr', the controller CONT performs the liquid removal process by the liquid removing system 90 and then transports the substrate P in which the error occurs to the predetermined retreat position; and when the elapsed time Tb exceeds the allowable time Tr', the controller immediately transports the substrate P in which the error occurs to the cleaning device 100, and after performing the cleaning process, the controller transports the substrate to the predetermined retreat position. By doing so, it is possible to prevent the occurrence of the water mark on the substrate P in which the error is occurred.

In a case in which a judgment is made that the elapsed time Tb exceeds the predetermined time Tr' and the substrate P is transported to the cleaning device 100 without being subjected to the liquid removal process in the liquid removing system 90, when there is a possibility that the liquid remaining on the substrate P is dried before the substrate is transported to the cleaning device 100, then the liquid LQ may be supplied onto the substrate P before the substrate is unloaded or at an intermediate point in the transport of the substrate P. In the above-described embodiment, although the liquid removing system 90 is disposed inside the exposure apparatus EX-SYS, it is allowable to dispose the liquid removing system 90 in the interface IF or in the coater/developer C/D-SYS.

In the above-described embodiment, the occurrence of the water mark on the substrate P is prevented by managing the liquid contact time Ta of the substrate P and/or the elapsed time Tb after the liquid immersion area is removed on the substrate P. However, it is also allowable that the substrate P is unloaded from the substrate stage PST while in a wet state without performing such time management and that the substrate P is immediately transported to the cleaning device 100 of the coater/developer C/D-SYS.

In the above-described embodiment, it is judged whether or not the liquid contact time Ta exceeds the allowable time Tr and various processes are performed. It is allowable, however, that the liquid contact time Ta, namely the period of time during which the liquid immersion state is maintained can be set based on the allowable time Tr. In particular, the liquid contact time Ta can be set for each of the combinations of the liquid LQ and the material of the substrate P (in particular, material of the film which makes contact with the liquid LQ). This makes possible to minimize the influence which is due to the contact between the liquid and substrate and which is considered to affect the exposure characteristics of the liquid immersion exposure, thereby making it possible to realize optimum liquid immersion exposure. The liquid contact time Ta set for each of the combinations of the liquid LQ and the material of the substrate P may be stored in advance in the controller or a storage device of the exposure apparatus.

In the embodiment, since the substrate P is transported in a wet state, the liquid recovery mechanism 20 can be omitted. It is also allowable that the recovering operation of the liquid recovery mechanism 20 is performed such that an appropriate amount of the liquid remains on the substrate P to thereby prevent the substrate P from drying until the substrate P is transported to the cleaning device 100. It is also possible to perform a predetermined process for the surface of the substrate P so that an appropriate amount of the liquid remains on the substrate P even after the liquid immersion area AR2 has been removed on the substrate P by performing liquid recovery by the liquid recovery mechanism 20, thereby preventing the substrate P from drying until the substrate P is transported to the cleaning device 100. For example, a predetermined film can be formed on the surface of the substrate P so as to reduce the contact angle (including dynamic contact angle) on the surface of the substrate P with respect to the liquid LQ. The contact angle is determined depending on the combination of the liquid LQ and the material forming the surface (surface coming into contact with the liquid) of the substrate P. Accordingly, by selecting the combinations in advance, it is possible to control the extent how easily the liquid LQ remains on the substrate and the allowable range for the liquid contact time during which the substrate and the liquid LQ are in contact with each other. Namely, in the present invention, the contact angle of the substrate with respect to the liquid is set such that the liquid remains on the substrate after the liquid immersion area has been removed on the substrate, thereby making it possible to suppress the formation of the adhesion mark (water mark) of the liquid on the substrate. In the above-described embodiment, the liquid contact time Ta of the substrate P and/or the elapsed time Tb after the liquid immersion area is removed on the substrate P are managed so as to prevent the occurrence of water mark on the substrate P. However, the purpose of management of the liquid contact time Ta of the substrate P and/or the elapsed time Tb after the liquid immersion area on the substrate P is removed is not limited to this. For example, in some cases, when the contact time between the substrate P and the liquid LQ exceeds the allowable time, the photosensitive material 3 of the substrate P is altered, which in turn causes abnormality in the line width of the pattern to be formed on the substrate P after the developing. There is a possibility that the error in the line width error of the pattern formed on the substrate P causes the device defect. Therefore, the liquid contact time Ta and/or the allowable time Tr of the elapsed time Tb may be set by considering the change in the line width of the pattern to be formed on the substrate. In this case, when the liquid contact time Ta has exceeded the allowable time Tr, it is possible to adjust the heating-process condition (heating temperature, heating time, etc.) to be performed for the substrate P after the liquid immersion exposure in the coater/developer C/D-SYS, to thereby prevent the error in the line width of the pattern. In a case that it is known in advance that the liquid contact time Ta will exceed the allowable time Tr, then the dose amount for the substrate P during the liquid immersion exposure may be adjusted so as to prevent the error in the line width of the pattern.

As described above, pure or purified water is used as the liquid LQ in this embodiment. Pure or purified water can be easily acquired in large quantities in a semiconductor producing factory or the like, and is advantageous since the pure or purified water has no harmful influences on the photoresist on the substrate P and the optical element (lens), etc. In addition, the pure water or purified water has no harmful influence on the environment, and has a very low content of impurities, so that it is expected to clean (wash) the surface of the substrate P and the surface of the optical element provided on the end surface of the projection optical system PL. When the purity of the pure or purified water supplied from the factory or the like is low, the exposure apparatus may be provided with an ultrapure water-producing unit.

It is approved that the refractive index n of pure water (water) with respect to the exposure light beam EL having a wavelength of about 193 nm is approximately 1.44. When the ArF excimer laser beam (wavelength: 193 nm) is used as the light source of the exposure light beam EL, then the wavelength is shortened on the substrate P by 1/n, i.e., to about 134 nm, and a high resolution is obtained. Further, the depth of focus is magnified about n times, i.e., about 1.44 times as compared with the value obtained in the air. Therefore, when it is enough to secure an approximately equivalent depth of focus as compared with the case of the use in the air, it is possible to further increase the numerical aperture of the projection optical system PL. Also in this viewpoint, the resolution is improved.

In the embodiments described above, the optical element LS1 is attached to the end portion of the projection optical system PL, and it is possible to adjust, with this lens, the optical characteristics, for example, aberrations (spherical aberration, coma aberration, etc.,) of the projection optical system PL. The optical element to be attached to the end portion of the projection optical system PL may also be an optical plate used for adjusting the optical characteristics of the projection optical system PL. Alternatively, the optical element may be a plane-parallel through which the exposure light beam EL is transmissive.

When the pressure between the optical element at the end portion of the projection optical system PL and the substrate P generated due to the flow of the liquid LQ is great, the optical element may be firmly fixed so as not to be moved by the pressure, instead of making the optical element exchangeable.

In the embodiment, although the liquid LQ is filled between the projection optical system PL and the surface of the substrate P, it is also allowable that the liquid LQ is filled in a state that, for example, a cover glass formed of a plane-parallel is attached to the surface of the substrate P.

In the above-described embodiment, although the projection optical system fills, with the liquid, the optical path space on the side of the image plane of the optical element on the end portion, it is also possible to adopt a projection optical system which also fills with a liquid the optical path space, on a side of the mask, of the optical element at the end portion, as disclosed in pamphlet of International Publication No. 2004/019128.

Although the liquid LQ in the above-described embodiment is water (pure or purified water), the liquid may be a liquid other than water. For example, when the light source of the exposure light beam EL is the F₂ laser, the F₂ laser beam is not transmitted through water. Therefore, the liquid LQ may be a fluorine-based liquid including, for example, perfluoropolyether (PFPE) and fluorine-based oil etc. through which the F₂ laser beam is transmissive. In this case, the portion, which makes contact with the liquid LQ, is subjected to the liquid-attracting treatment, for example, by forming a thin film with a substance having a molecular structure with small polarity including fluorine. Alternatively, other than the above, it is also possible to use, as the liquid LQ, liquids (for example, cedar oil) which have the transmittance with respect to the exposure light beam EL, which have the refractive index as high as possible, and which are stable against the photoresist coated on the surface of the substrate P and the projection optical system PL. In this case also, the surface treatment is performed depending on the polarity of the liquid LQ to be used. It is also possible to use, as the liquid LQ, various liquids such as a supercritical fluid for example.

The substrate P of the above-described embodiment is not limited to a semiconductor wafer for producing a semiconductor device. Substrates applicable include, for example, a glass substrate for the display device, a ceramic wafer for the thin film magnetic head, and a master plate (synthetic silica glass, silicon wafer) for the mask or the reticle to be used for the exposure apparatus.

As for the exposure apparatus EX, the present invention is also applicable to a scanning type exposure apparatus (scanning stepper) based on the step-and-scan system for performing the scanning exposure for the pattern of the mask M by synchronously moving the mask M and the substrate P as well as a projection exposure apparatus (stepper) based on the step-and-repeat system for performing the full field exposure with the pattern of the mask M in a state in which the mask M and the substrate P are allowed to stand still, while successively step-moving the substrate P by using the substrate stage.

As for the exposure apparatus EX, the present invention is also applicable to an exposure apparatus of the system in which the substrate P is subjected to the full field exposure by using a projection optical system with a reduction image of a first pattern (for example, a dioptric type projection optical system including no catoptric element with a reduction magnification of 1/8) in a state that the first pattern and the substrate P are allowed to substantially stand still. In this case, the present invention is also applicable to a full field exposure apparatus based on the stitch system in which, subsequent to the exposure operation for the first pattern as described above, the substrate P is subjected to the full field exposure while partially overlaying a reduction image of a second pattern on the first pattern by using the projection optical system in a state that the second pattern and the substrate P are allowed to substantially stand still thereafter. As for the exposure apparatus based on the stitch system, the present invention is also applicable to an exposure apparatus based on the step-and-stitch system in which at least two patterns are partially overlaid and transferred on the substrate P, and the substrate P is successively moved. Although the above-described embodiment is explained, by way of example, by the exposure apparatus provided with the projection optical system PL, the present invention is also applicable to an exposure apparatus and an exposure method which do not use any projection optical system PL.

The present invention is also applicable to a twin-stage type exposure apparatus. The structure and exposure operation of the twin-stage type exposure apparatus are disclosed, for example, in Japanese Patent Application Laid-open Nos. 10-163099 and 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), or United States Patent No. 6,208,407, contents of which are incorporated herein by reference within a range of permission of the domestic laws and ordinances of the state designated or selected in this international application.

The present invention is also applicable to an exposure apparatus including a substrate stage which holds a substrate and a measuring stage which is provided with various photoelectric sensors and/or a reference mark thereon, as disclosed in Japanese Patent Application Laid-open No. 11-135400.

The embodiment described above adopts the exposure apparatus in which a liquid is locally filled between the projection optical system PL and the substrate P. However, the present invention is also applicable to a liquid immersion exposure apparatus which performs the exposure in a state in which the entire surface of the substrate as the exposure-objective is immersed in the liquid as disclosed, for example, in Japanese Patent Application Laid-open Nos. 6-124873 and 10-303114 and United States Patent No. 5,825,043. The structure and exposure operation of such a liquid immersion exposure apparatus are disclosed in detail in United States Patent No. 5,825,043, contents of which are incorporated herein by reference within a range of permission of the domestic laws and ordinances of the state designated or selected in this international application.

The type of the exposure apparatus EX is not limited to the exposure apparatus for producing the semiconductor element which exposes the semiconductor element pattern on the substrate P. The present invention is also widely applicable, for example, to an exposure apparatus for producing the liquid crystal display device or producing the display as well as to an exposure apparatus for producing, for example, the thin film magnetic head, the image pickup element (CCD), the reticle, the mask, or the like.

When the linear motor is used for the substrate stage PST and/or the mask stage MST, it is allowable to use any one of those of the air floating type using the air bearing and those of the magnetic floating type using the Lorentz's force or the reactance force. Each of the stages PST, MST may be either of a type in which the movement is effected along a guide or of a guideless type in which no guide is provided. An example using the linear motor for the stage is disclosed in United States Patent Nos. 5,623,853 and 5,528,118, contents of which are incorporated herein by reference respectively within a range of permission of the domestic laws and ordinances of the state designated or selected in this international application.

As for the driving mechanism for each of the stages PST, MST, it is also allowable to use a plane motor in which a magnet unit provided with two-dimensionally arranged magnets and an armature unit provided with two-dimensionally arranged coils are opposed to each other, and each of the stages PST, MST is driven by the electromagnetic force. In this case, any one of the magnet unit and the armature unit may be connected to the stage PST, MST, and the other of the magnet unit and the armature unit may be provided on the side of the movable surface of the stage PST, MST.

The reaction force, which is generated in accordance with the movement of the substrate stage PST, may be mechanically released to the floor (ground) by using a frame member so that the reaction force is not transmitted to the projection optical system PL, as described in Japanese Patent Application Laid-open No. 8-166475 (United States Patent No. 5,528,118). The contents of United States Patent No. 5,528,118 are incorporated herein by reference within a range of permission of the domestic laws and ordinances of the state designated or selected in this international application.

The reaction force, which is generated in accordance with the movement of the mask stage MST, may be mechanically released to the floor (ground) by using a frame member so that the reaction force is not transmitted to the projection optical system PL, as described in Japanese Patent Application Laid-open No. 8-330224 (United States Patent No. 5,874,820). The contents of United States Patent No. 5,874,820 is incorporated herein by reference within a range of permission of the domestic laws and ordinances of the state designated or selected in this international application.

As described above, the exposure apparatus EX according to the embodiment of the present invention is produced by assembling the various subsystems including the respective constitutive elements as defined in claims so that the predetermined mechanical accuracy, electric accuracy, and optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include, for example, the mechanical connection, the wiring connection of the electric circuits, and the piping connection of the air pressure circuits in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which the temperature, the cleanness and the like are managed.

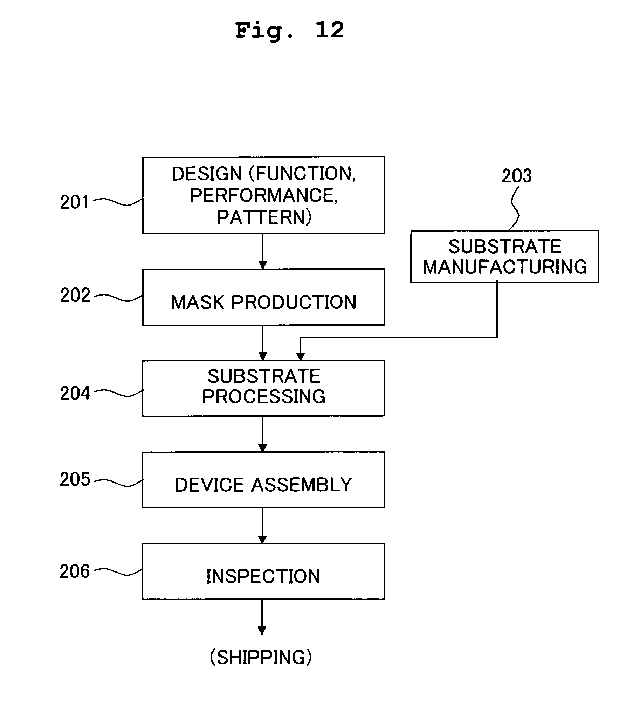

As shown in Fig. 12, a microdevice such as the semiconductor device is produced by performing a step 201 of designing the function and the performance of the microdevice, a step 202 of producing a mask (reticle) based on the designing step, a step 203 of manufacturing a substrate as a base material for the device, a substrate processing step 204 of exposing the substrate with a pattern of the mask by using the exposure apparatus EX of the embodiment described above, a step 205 of assembling the device (including processing steps such as a dicing step, a bonding step, and a packaging step), and an inspection step 206. The substrate processing step 204 includes the processes described in Figs. 6(A), 6(B), and 11.

## Claims

1. A method for processing a substrate, comprising:
forming a liquid immersion area of a liquid on a substrate and performing exposure for the substrate by irradiating an exposure light onto the substrate through the liquid in the liquid immersion area; and
managing a liquid contact time during which the substrate is in contact with the liquid in the liquid immersion area.

2. The method for processing the substrate according to claim 1, wherein the liquid on the substrate is removed to prevent the liquid contact time from exceeding a predetermined allowable time.

3. The method for processing the substrate according to claim 2, further comprising removing the liquid immersion area on the substrate,
wherein when the liquid remains on the substrate after the liquid immersion area has been removed on the substrate, a liquid-remaining time during which the liquid remains on the substrate is also included in the liquid contact time.

4. The method for processing the substrate according to claim 2, wherein the substrate includes a base material and a film formed on a surface of the base material; and the allowable time is set based on information about the substrate.

5. The method for processing the substrate according to claim 4, wherein the base material is made of silicon.

6. The method for processing the substrate according to claim 4, wherein the allowable time is set such that an adhesion mark of the liquid is not formed on the substrate.

7. An exposure method, comprising the method for processing the substrate as defined in claim 1.

8. A method for processing a substrate, comprising:
forming a liquid immersion area of a liquid on the substrate and performing exposure for the substrate by irradiating an exposure light onto the substrate through the liquid in the liquid immersion area;
removing the liquid immersion area on the substrate; and
managing a time after the liquid immersion area has been removed on the substrate.

9. The method for processing the substrate according to claim 8, wherein the liquid remaining on the substrate is removed before a time, elapsed after the liquid immersion area has been removed on the substrate, exceeds a predetermined allowable time.

10. The method for processing the substrate according to claim 9, wherein the substrate includes a base material and a film formed on a surface of the base material; and
the allowable time is set based on information about the substrate.

11. The method for processing the substrate according to claim 10, wherein the base material is made of silicon.

12. The method for processing the substrate according to claim 8, wherein the allowable time is set such that an adhesion mark of the liquid is not formed on the substrate.

13. The method for processing the substrate according to any one of claims 8 to 12, wherein a judgment is made whether or not the liquid remaining on the substrate is to be removed, depending on a time elapsed after the liquid of the liquid immersion area has been removed on the substrate.

14. An exposure method, comprising the method for processing the substrate as defined in claim 8.

15. A method for processing a substrate, comprising:
forming a liquid immersion area of a liquid on the substrate and performing exposure for the substrate by irradiating an exposure light onto the substrate through the liquid in the liquid immersion area;
removing the liquid immersion area on the substrate; and
setting a contact angle of the substrate with respect to the liquid so that the liquid remains on the substrate after the liquid immersion area has been removed on the substrate.

16. The method for processing the substrate according to claim 15, wherein the contact angle is set so that an adhesion mark of the liquid is not formed on the substrate.

17. The method for processing the substrate according to claim 15, wherein the contact angle is set by selecting the liquid and a material of the surface of the substrate which comes into contact with the liquid.

18. An exposure method, comprising the method for processing the substrate as defined in claim 15.

19. An exposure apparatus which forms a liquid immersion area of a liquid on a substrate and exposes the substrate by irradiating an exposure light onto the substrate through the liquid in the liquid immersion area, the exposure apparatus comprising:
a substrate holder which holds the substrate;
a liquid removing mechanism which removes the liquid on the substrate; and
a controller which manages a liquid contact time during which the substrate is in contact with the liquid in the liquid immersion area.

20. The exposure apparatus according to claim 19,
wherein the liquid removing mechanism removes the liquid on the substrate so as to prevent the liquid contact time from exceeding a predetermined allowable time.

21. The exposure apparatus according to claim 20,
wherein the liquid removing mechanism removes the liquid on the substrate after unloading the substrate from the substrate holder.

22. The exposure apparatus according to claim 20,
wherein the liquid removing mechanism removes the liquid on the substrate before unloading the substrate from the substrate holder.

23. The exposure apparatus according to any one of claims 19 to 22, wherein the exposure apparatus is connected to a substrate processing device which performs developing process for the substrate for which the exposure has been performed; and
when the liquid contact time exceeds a predetermined allowable time, the substrate is transported to the substrate processing device without removing the liquid by the liquid removing mechanism.

24. The exposure apparatus according to claim 19,
wherein the controller manages the liquid contact time depending on at least one of a substrate to be exposed and a liquid to be used.

25. The exposure apparatus according to claim 24, further comprising a storage device which stores information about the liquid contact time depending on at least one of the substrate to be exposed and the liquid to be used.

26. The exposure apparatus according to claim 19, further comprising a timer which measures the liquid contact time.

27. An exposure apparatus which forms a liquid immersion area of a liquid on a substrate and exposes the substrate by irradiating an exposure light onto the substrate through the liquid in the liquid immersion area, the exposure apparatus comprising:
a substrate holder which holds the substrate; and
a transport system which transports a substrate, which comes into contact with the liquid forming the liquid immersion area, from the substrate holder while the substrate is in a wet state.

28. The exposure apparatus according to claim 27,
wherein a contact angle of the substrate with respect to the liquid is set such that the liquid remains on the substrate after the liquid immersion area has been removed on the substrate.

29. The exposure apparatus according to claim 27, further comprising a cleaning device which cleans the substrate unloaded from the substrate holder.

30. The exposure apparatus according to any one of claims 27 to 29, wherein the exposure apparatus is connected to a substrate processing device which performs developing process for the substrate for which the exposure has been performed; and
the transport system transports the substrate to the substrate processing device while the substrate is in the wet state.

31. An exposure apparatus which forms a liquid immersion area of a liquid on a substrate and exposes the substrate by irradiating an exposure light onto the substrate through the liquid in the liquid immersion area, the exposure apparatus comprising:
a substrate holder which holds the substrate; and
a controller which manages a liquid contact time during which the substrate is in contact with the liquid in the liquid immersion area.

32. The exposure apparatus according to claim 31,
wherein the controller manages a predetermined allowable time regarding the liquid contact time.

33. The exposure apparatus according to claim 32,
wherein the allowable time is set depending on at least one of a substrate to be exposed and a liquid to be used.

34. The exposure apparatus according to claim 33, comprising a storage device which stores information about the allowable time.

35. The exposure apparatus according to claim 31, further comprising a timer which measures the liquid contact time.

36. A method for producing a device, comprising using the exposure apparatus as defined in any one of claims 19, 27 and 31.
